# EUROPÄISCHE PATENTSCHRIFT

(11) **EP 3 129 972 B1**
(45) Veröffentlichungstag und Bekanntmachung des Hinweises auf die Patenterteilung: **24.10.2018**
(21) Anmeldenummer: 15717130.7
(22) Anmeldetag: 09.04.2015
(51) Int. Cl.: G09F 3/02, B01D 65/00, B65D 77/22, G09F 3/10, H05K 5/02, H05K 5/06

(54) **DRUCKAUSGLEICHSETIKETT ZUM AUFKLEBEN AUF EINE OBERFLÄCHE UND VERFAHREN**
PRESSURE COMPENSATION LABEL FOR STICKING TO A SURFACE, AND METHOD
ÉTIQUETTE DE COMPENSATION DE PRESSION DESTINÉE À ÊTRE COLLÉE SUR UNE SURFACE ET PROCÉDÉ

(30) Priorität: 11.04.2014 DE 102014105193
(43) Veröffentlichungstag der Anmeldung: 15.02.2017
(73) Patentinhaber: Schreiner Group GmbH & Co. KG, 85764 Oberschleissheim (DE)
(72) Erfinder: BIRK, Uwe, 80995 München (DE)
(74) Vertreter: Epping - Hermann - Fischer
(86) Internationale Anmeldenummer: PCT/EP2015/057749
(87) Internationale Veröffentlichungsnummer: WO 2015/155299

(56) Entgegenhaltungen:
- EP-A1- 1 593 478
- EP-A1- 1 630 769
- WO-A1-2009/142987

## Beschreibung

Die Anmeldung betrifft ein Druckausgleichsetikett zum Aufkleben auf eine mit einer Druckausgleichsöffnung versehene Oberfläche eines Gehäuses oder eines sonstigen Gegenstandes. Die Anmeldung betrifft ferner ein Verfahren zum Herstellen von Druckausgleichsetiketten.

Verschiedenste Anlagen, Geräte, Komponenten oder Einzelteile im Maschinenbau, im Automobilbau oder in sonstigen Anwendungsgebieten besitzen Druckausgleichsöffnungen. Vor allem Gehäuse bzw. Außengehäuse sind oft mit einer oder mehreren Druckausgleichsöffnungen versehen. Bei Geräten, die bei tages- und jahreszeitlich schwankenden Temperaturen betrieben werden oder aufgrund ihres Stromverbrauchs selbst Wärme erzeugen, sind Druckausgleichsöffnungen beispielsweise erforderlich, damit die im Gerätegehäuse befindliche Luft sich je nach Betriebstemperatur erforderlichenfalls ausdehnen bzw. das Gehäuse teilweise verlassen kann oder beim Erkalten wieder Luft in das Gehäuse zurückströmen kann.

Insbesondere in Komponenten, die zur Kontrolle von Fahrzeugparametern in Kraftfahrzeugen oder sonstigen Verkehrsmittel eingebaut sind, erzeugt die komponenteneigene Elektronik Wärme, die nicht nur die Komponente und ihr Gehäuse aufheizt, sondern auch die darin eingeschlossene Luft. Ohne einen Druckausgleich entstünde im Gehäuse der elektronischen Komponente ein Überdruck gegenüber der Außenumgebung, der je nach Umgebungstemperatur, Nutzungsintensität und elektrischem Leistungsverbrauch der elektronischen Komponente während ihres Betriebs bis zu 300, 500 oder sogar 700 mbar erreichen kann. Ähnliche Probleme des Druckausgleichs können außer im Automobilbau auch an sonstigen Maschinen, Industrieanlagen oder Geräten entstehen. Gehäuse elektronischer Komponenten sind daher oft mit Druckausgleichsöffnungen versehen, beispielsweise in Form von Bohrlöchern oder sonstigen Durchlässen in der Gehäusewandung.

Solche Druckausgleichsöffnungen bleiben nicht exponiert bzw. freiliegend, sondern werden so abgedeckt, dass ein Druckausgleich durch Gasaustausch zwar weiterhin möglich ist, aber Nässe bzw. Feuchtigkeit und Wasser nicht in das Gehäuse der Komponente eindringen können. Neben massiven, dreidimensional ausgeformten Verschlüssen für Druckausgleichsöffnungen kommen insbesondere Verschlüsse in Form von Druckausgleichsetiketten zum Einsatz; diese sind aus Folien herstellbar und daher relativ kostengünstig. Aber auch etikettenartige Druckausgleichsverschlüsse müssen robust genug sein, um Witterungseinflüssen und sonstigen mechanischen Beanspruchungen zu widerstehen; insbesondere den beim Einsatz von Dampfstrahlgeräten bzw. Hochdruckreinigern auftretenden Kräften. Derartige Einsatzbedingungen erfordern bislang einen eher komplexen Aufbau von Druckausgleichsetiketten, bei dem zusätzlich zu Folien und Klebeschichten auch Stützstrukturen zwischen den Folien erforderlich sein können.

EP 1 593 478 A1 betrifft ein Verfahren zum Abdecken und Belüften eines Funktionsbereichs sowie eine Folienanordnung zum Schutz mindestens eines insbesondere vor Spritzwasser zu schützenden Funktionselements.

WO 2009/142987 bezieht sich auf Behälter für Produkte, die nach dem Füllen und Versiegeln der Behälter dazu neigen, Gase freizusetzen, und bezieht sich insbesondere auf Behälter mit einer Gasfreisetzungsöffnung oder einem Ventil zum Freisetzen überschüssiger Gase, die in dem Behälter aufgebaut sind.

Es ist die Aufgabe der vorliegenden Anmeldung, ein möglichst einfach aufgebautes, möglichst einfach herstellbares und somit preiswertes Druckausgleichsetikett bereitzustellen, das mechanisch sehr stabil und widerstandsfähig gegen äußere mechanische Belastungen ist. Ferner soll ein Verfahren bereitgestellt werden, mit dem mechanisch widerstandsfähige Druckausgleichsetiketten einfach und kostengünstig herstellbar sind.
Diese Aufgabe wird durch den Gegenstand der Ansprüche 1 und 13 gelöst.
Das Druckausgleichsetikett gemäß Anspruch 1 besitzt eine untere, erste Folie und eine über ihr bzw. weiter oben angeordnete äußere, zweite Folie sowie eine Membranfolie. Gemäß dieser Anmeldung ist die Membranfolie zwischen der ersten Folie und der zweiten Folie angeordnet. Die Membranfolie ist gasdurchlässig und insbesondere luftdurchlässig, aber undurchlässig für Feuchtigkeit und Wasser oder sonstige Flüssigkeiten. Die Membranfolie ist eine dünne Schicht aus geeignetem Membranmaterial; hierzu kann jede herkömmliche Membranfolie eingesetzt werden. Die unter der Membran angeordnete erste Folie, deren Unterseite auf die Oberfläche des Gerätes, der elektronischen Komponente oder dem Gehäuse aufzukleben oder aufgeklebt ist, besitzt - zweckmäßigerweise in ihrer Mitte - eine Aussparung, die genau über der Druckausgleichsöffnung des Gerätes bzw. Gehäuses zu positionieren ist. Diese Aussparung in der unteren, ersten Folie bildet den geräteseitigen Zugang zur Unterseite der Membranfolie des Druckausgleichsetiketts. Die erste Folie wird ansonsten mit ihrer Unterseite bzw. mittels einer unterseitigen Klebeschicht auf die Gehäusewandung des Gerätes oder der elektronischen Komponente geklebt, und zwar in unmittelbarer Umgebung der abzudichtenden Druckausgleichsöffnung. Durch das Druckausgleichsetikett wird beispielsweise ein kreisringförmiger bzw. kreisscheibenförmiger Oberflächenbereich des Gehäuses beklebt, wobei das Druckausgleichsetikett natürlich auch die Druckausgleichsöffnung selbst überdeckt, und zwar mit der Membranfolie und auch mit der äußeren, d.h. oberen zweiten Folie. Die erste und die zweite Folie sind insbesondere Kunststofffolien.

Die erste und die zweite Folie erstrecken sich seitlich bis über die Membranfolie hinaus; insbesondere können deren Randbereiche seitlich außerhalb der Membranfolie vollständig um die Membranfolie umlaufen.

Es ist vorgesehen, dass die erste Folie zusätzlich zur Aussparung für die Druckausgleichsöffnung noch eine Anzahl von Lüftungskanälen aufweist. Diese sind in die erste Folie eingearbeitet bzw. Bestandteil von ihr. Weiterhin ist vorgesehen, dass jeder der Lüftungskanäle in der ersten Folie durch einen jeweiligen Folienbereich der ersten Folie von der Aussparung für die Druckausgleichsöffnung getrennt ist. Zwischen der zentralen Aussparung über der Druckausgleichsöffnung und den Lüftungskanälen in der ersten Folie bestehen somit Trennbereiche, die als Materialstege bzw. Materialbrücken in der Folienebene die direkte Verbindung zwischen der zentralen Aussparung und den Lüftungskanälen versperren. Diese Folienbereiche brauchen nicht in besonderer Weise ausgebildet oder verstärkt zu sein, sondern sind lediglich unversehrt gebliebene, also insbesondere nicht ausgestanzte oder anderweitig geschwächte oder bearbeitete Folienbereiche der ersten Folie. Während beispielsweise die Aussparung und die Lüftungskanäle in der erste Folie als Ausstanzungen der ersten Folien realisiert sein können, stellen die zu deren Trennung vorgesehenen Folienbereiche beispielsweise unversehrte, weder durch Stanzung noch durch sonstige Einwirkungen bearbeitete Brückenbereiche zwischen der Aussparung und dem Lüftungskanal oder den Lüftungskanälen dar.

Bei diesem Folienaufbau eines Druckausgleichsetiketts, bei dem die Membranfolie oberhalb der ersten Folie, d.h. zwischen dieser und der zweiten Folie angeordnet ist, würde der Fachmann den weiteren Lüftungsweg üblicherweise in Höhe oberhalb der Membranfolie oder zumindest oberhalb der ersten Folie gestalten, da bei Erwärmung des Gehäuses die eingeschlossene Luft, die durch die Druckausgleichsöffnung des Gehäuses und die Aussparung der ersten Folie hindurch die Membranfolie erreicht, auf der Oberseite der Membranfolie aus dieser austritt. Gemäß diese Anmeldung wird jedoch der weitere Lüftungsweg wieder in die Ebene der unteren, ersten Folie zurückgeführt, d.h. hinunter bis in die Ebene der ersten Folie 1, die direkt auf das Gehäuse der elektronischen Komponente oder des sonstigen Gerätes aufzukleben oder aufgeklebt ist. Infolge dieser Positionierung der Lüftungskanäle bzw. weiteren Aussparungen mag die erste Folie, die für die unmittelbare Haftung des Druckausgleichsetiketts am Gehäuse verantwortlich ist, zwar in der Draufsicht strukturell eher geschwächt aussehen und somit daher das Einbringen von Lüftungskanälen ausgerechnet in die erste, unterste Folie auf den ersten Blick abwegig erscheinen. Jedoch lässt sich bei dieser Konstruktionsweise - in Verbindung mit weiteren Merkmalen, die nachstehend erläutert werden - besonders einfach ein mechanisch robuster Gesamtaufbau des Druckausgleichsetiketts erzielen, zumal die erste Folie sowohl während der Etikettenherstellung als auch nach dem Verspenden des Druckausgleichsetiketts beidseitig durch die angrenzenden Materialoberflächen in Form gehalten wird und zudem selbst eine stark vergrößerte, nahezu vollflächige Klebefläche bietet.

Zunächst ist vorgesehen, dass die Membranfolie die Aussparung sowie die Folienbereiche zwischen der Aussparung und jedem der Lüftungskanäle bedeckt. Beispielsweise wird die Aussparung für die Druckausgleichsöffnung und ihre gesamte Umrandung mit der Membranfolie bedeckt und so feuchtigkeitsdicht versiegelt. Weiterhin ist vorgesehen, dass die äußere Folie, d.h. die zweite Folie sich seitlich über die Membranfolie hinaus erstreckt, dass die zweite Folie seitlich außerhalb der Membranfolie zumindest bereichsweise die Anzahl von Lüftungskanälen der ersten Folie abdeckt und dass die zweite Folie ferner einen Lüftungsweg überspannt, der von derjenigen Oberfläche der Membranfolie, die der zweiten Folie zugewandt ist, bis zu der Anzahl von Lüftungskanälen der ersten Folie führt. Erhitzt sich also Luft in einem Gehäuse, das mit dem hier beschriebenen Druckausgleichsetikett beklebt ist, so durchquert sie beim Hindurchtreten durch das Etikett zuerst die Membranfolie, bevor sie die Lüftungskanäle erreicht.

Dadurch, dass sich die zweite Folie (ebenso wie die erste Folie) seitlich bis über die Membranfolie hinaus erstreckt, lässt sich dank der in die erste Folie eingebrachten Lüftungskanäle der weitere Lüftungsweg nach außen allein mit Hilfe der ersten und zweiten Folie gestalten. Eigentlich wären zwischen beiden Folien zusätzliche Schichten für die Kanäle oder zumindest erhöhte Klebepunkte vorzusehen, damit zwischen ihnen die Luft nach außen entweichen bzw. wieder einströmen kann. Insbesondere im Außenbereich - nahe des Umfangs des Druckausgleichsetiketts - wären eigentlich zusätzliche Folien, Klebepunkte, Materialschichten oder sonstige Strukturen mit eingebetteten Kanälen auszubilden, um den Lüftungsweg von der Membranoberseite bzw. deren Mitte aus nach draußen, d.h. hin zur Umgebung des Etiketts zu realisieren.

Da gemäß dieser Anmeldung jedoch die erste Folie bereits eine Anzahl von Lüftungskanälen in sich trägt, können solche zusätzlichen Klebepunkte, Folienschichten oder Strukturen ersatzlos entfallen. Die zweite Folie dient in Bereichen seitlich außerhalb der Membranfolie als obere Abdeckung der Lüftungskanäle; sie ist auf die erste Folie aufgeklebt, und zwar möglichst vollflächig. Die Ausnehmungen der ersten Folie sind - mit Ausnahme ihrer inneren, ggfs. auch äußeren Kanalenden - von der zweiten Folie abgedeckt und bilden die Lüftungskanäle ins Freie. Um den Lüftungsweg zwischen der Membranoberseite und den Kanalöffnungen nicht zu unterbrechen, genügt es, dass zumindest in einem schmalen Bereich um die Membranfolie herum die erste und die zweite Folie nicht unmittelbar aufeinander aufliegen, sondern einen gewissen Abstand voneinander besitzen. Ansonsten sind im ringförmigen Außenbereich des Druckausgleichsetiketts, d.h. seitlich außerhalb der Membranfolie keine weiteren Strukturen zur Kanalführung mehr erforderlich.
Je nach Ausführungsform können ansonsten noch weitere Strukturen zur Aufweitung des Lüftungsweges zwischen dem inneren Ende des jeweiligen Lüftungskanals und der Membranoberseite vorgesehen sein.

Das hier beschriebene Druckausgleichsetikett besitzt zunächst keine Abdeckung der Lüftungskanäle von unten her, sondern macht sich den Umstand zunutze, dass nach dem Verspenden des Etiketts die Gehäuseoberfläche selbst die erste Folie von unten umgibt. Bei herkömmlichen Druckausgleichsetiketten, soweit diese Lüftungskanäle in sich tragen, sind die Lüftungskanäle bereits fertig in das Etikett eingearbeitet, d.h. sowohl nach oben hin (in Richtung weg von der Gehäuseoberfläche) als auch nach unten hin (in Richtung hin zur Gehäuseoberfläche) begrenzt. Bei einem Druckausgleichsetikett gemäß dieser Anmeldung hingegen "entstehen" die unterseitigen Begrenzungen der Lüftungskanäle erst mit dem Aufspenden des Etiketts auf die Geräte- oder Gehäuseoberfläche.

Bei dem hier beschriebenen Etikett liegt seitlich außerhalb der Membran die zweite Folie direkt und großflächig auf der ersten Folie auf. Durch diesen großflächigen Auflageflächenbereich, innerhalb dessen die erste und die zweite Folie direkt aneinander angrenzen oder allenfalls durch eine dazwischenliegende Klebeschicht getrennt sind, ist das Druckausgleichsetikett besonders stabil und mechanisch widerstandsfähig gegenüber äußeren mechanischen Belastungen einschließlich Druck- und Scherkräften. Zudem kommt das Etikett mit weniger Folien oder sonstigen Bestandteilen aus und ist daher besonders einfach und kostengünstig herstellbar.

Die Lüftungskanäle sorgen für einen seitlichen Versatz der jeweiligen Außenöffnung im Etikett und der Membranoberseite, um diese vor einer Zerstörung durch Hochdruckreiniger bzw. Dampfstrahlgeräte oder vor sonstigen Belastungen und/oder Verunreinigungen zu schützen. Die Lüftungskanäle der ersten Folie können je nach Ausführungsform wahlweise am Außenrand der ersten Folie ins Freie führen oder - wenn das äußere Kanalende nicht bis an den Folienrand heranreicht - durch Kanalaustrittsöffnungen der zweiten Folie ins Freie führen.

Einige beispielhafte Ausführungsformen werden nachstehend in Bezug auf die Figuren beschrieben. Es zeigen:
- die Figuren 1A bis 1C: beispielhafte Gestaltungsmuster der unteren, ersten Folie eines Druckausgleichsetiketts,
- die Figuren 2A bis 2C: beispielhafte Zuschnitte einer Membranfolie auf der ersten Folie der Figuren 1A bis 1C,
- die Figuren 3A und 3B: schematische Draufsichten auf die äußere, zweite Folie eines Druckausgleichsetiketts, jeweils basierend auf Figur 1A und 2A,
- die Figuren 4A und 4B: alternative Ausführungsbeispiele hinsichtlich der Kanalaustrittsöffnungen der zweiten Folie in Figur 3A,
- die Figuren 5A und 5B: schematische Querschnittsansichten von Druckausgleichsetiketten, beispielsweise basierend auf Figur 3A,
- die Figuren 6A und 6B: zwei Ausführungsbeispiele mit einer zusätzlichen, luftdurchlässigen Materiallage als Abstandhalter auf der Membranfolie,
- Figur 7 eine: schematische Querschnittsansicht zu einer Ausführungsform ähnlich wie in Figur 6A oder 6B,
- die Figuren 8A und 8B: zwei abgewandelte Ausführungsbeispiele hinsichtlich der Form der zweiten Folie,
- Figur 9: eine schematische Draufsicht auf die zweite Folie aus Figur 8B,
- Figur 10: einen mit einem Druckausgleichsetikett versehenen Gegenstand,
- Figur 11: eine weitere Ausführungsform eines Druckausgleichsetiketts,
- Figur 12: eine alternative Ausführungsform zu Figur 9,
- Figur 13: eine alternative Ausführungsform zu Figur 2C,
- Figur 14: eine ergänzende schematische Ansicht zu Figur 2A mit zusätzlicher Darstellung des Auflageflächenbereichs und seines Innenrandes,
- Figur 15: eine zu den Figuren 2A und 14 alternative Ausführungsform mit einer über die inneren Enden der Lüftungskanäle überhängenden Membranfolie,
- Figur 16: eine ergänzende schematische Ansicht zu Figur 2B mit zusätzlicher Darstellung des Auflageflächenbereichs und seines Innenrandes,
- Figur 17: eine zu den Figuren 2B und 16 alternative Ausführungsform mit einer über die inneren Enden der Lüftungskanäle überhängenden Membranfolie und
- Figur 18: eine schematische Darstellung eines exemplarischen Verfahrens zur Herstellung von Druckausgleichsetiketten.

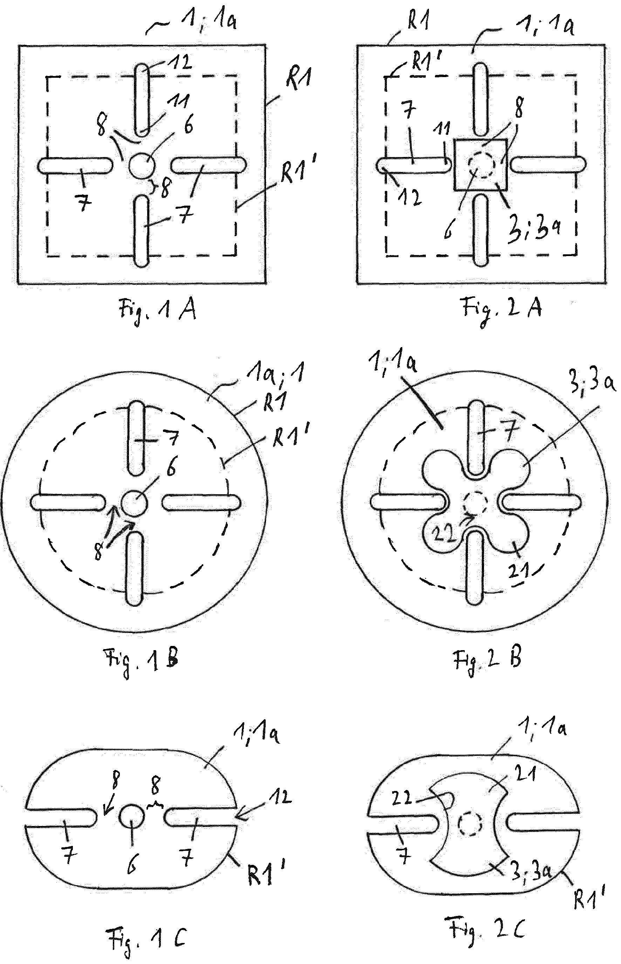

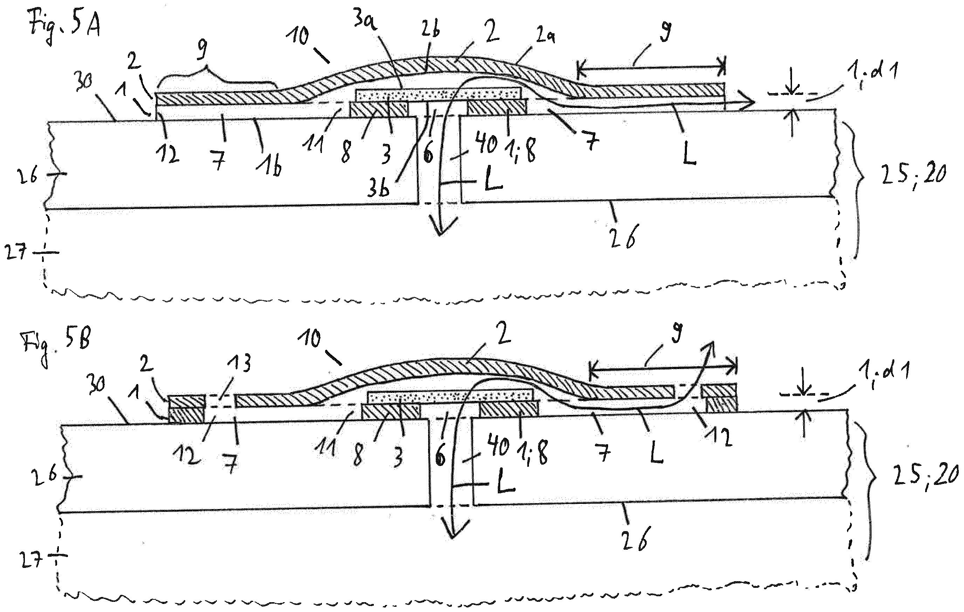

Die Figuren 1A bis 1C zeigen einige exemplarische Gestaltungsmuster für die untere (bzw. innere, d.h. direkt auf die Oberfläche des Gerätes oder Gehäuses aufzuklebende) erste Folie des Druckausgleichsetiketts. Die in den Figuren 1A bis 1C gezeigten Ansichten der ersten Folie 1 können beispielsweise als Schnittmuster bzw. Stanzmuster realisiert sein; insbesondere kann außer der zentralen Durchlassöffnung auch eine Anzahl von Lüftungskanälen in Form von Ausnehmungen bzw. Aussparungen ausgebildet sein, vor allem als Ausstanzungen der ersten Folie. Die Höhe der Lüftungskanäle entspricht dann der Schichtdicke d1 der ersten Folie (vgl. Figur 5A und 5B). Die Lüftungskanäle in der ersten Folie können jedoch alternativ auch als geschwächte, insbesondere im Vergleich zur sonstigen Foliendicke gedünnte Folienbereiche ausgebildet sein. Im einfachsten Fall jedoch wird die erste Folie im Bereich der Aussparung für die Druckausgleichsöffnung und auch im Bereich der Lüftungskanäle einfach ausgestanzt, d.h. mit einer entsprechenden Innenöffnung versehen.

Figur 1A zeigt ein erstes Ausführungsbeispiel, bei dem die hier quadratisch dargestellte erste Folie 1 eine mittig angeordnete Aussparung 6 aufweist, die beim Aufkleben des fertigen Druckausgleichsetiketts 10 (Figur 5A und 5B) auf eine Gehäuseoberfläche mit deren Druckausgleichsöffnung zur Deckung kommt. Die Druckausgleichsöffnung eines Gehäuses einer elektronischen Komponente oder eines elektronischen Gerätes ist meistens kreisförmig im Grundriss; gleiches gilt vorzugsweise für die Aussparung 6 der ersten Folie 1.

Die erste Folie 1 weist zusätzlich eine Anzahl von Lüftungskanälen 7 auf; diese sind vorzugsweise länglich und führen in seitlicher Richtung jeweils von innen nach außen, d.h. von einem Bereich nahe der Aussparung 6 zu einem Randbereich entfernt von der Aussparung 6. Beispielsweise verläuft jeder Lüftungskanal 7 gerade, d.h. linear; etwa wie abgebildet radial in Richtung von der Mitte der ersten Folie 1 des Druckausgleichsetiketts (bzw. seiner Aussparung 6) hin zum Etikettenrand. Jeder Lüftungskanal 7 besitzt ein inneres Ende 11 und ein äußeres Ende 12. Das innere Ende 11 ist jeweils durch einen Folienbereich 8 von der für die Druckausgleichsöffnung vorgesehenen Aussparung 6 getrennt.

Wie noch anhand einiger nachfolgender Figuren exemplarisch beschrieben werden wird, kann das innere Ende der Lüftungskanäle wahlweise mit der Membranfolie bedeckt sein oder stattdessen von der zweiten Folie (in einer gewissen Höhe über der ersten Folie) überdeckt sein.

Im letzteren Fall ist durch die Dicke der Membranfolie, die zumindest nah - beispielsweise zwischen 0,5 und 1,0 mm - bis an das innere Ende jedes Lüftungskanals heranreicht, und ggfs. auch durch die Dicke eines Abstandhalters über der Membranfolie gewährleistet, dass die zweite Folie in einem Abstand zur der ersten Folie die inneren Enden der Lüftungskanäle überspannt. Die zweite Folie liegt daher nicht unmittelbar auf den inneren Enden der Lüftungskanäle auf, sondern durch den Abstand der zweiten Folie von der ersten Folie über den inneren Enden der Lüftungskanäle wird der weitere Lüftungsweg, der von der Oberseite der inneren Enden der Lüftungskanäle bis zur Mitte der Oberseite der höher liegenden Membranfolie führt, freigehalten. Von dort aus passiert die Luft beim Druckausgleich dann die luftdurchlässige Membranfolie und gelangt dann durch die zentrale Aussparung der ersten Folie und durch die Druckausgleichsöffnung des überklebten, abkühlenden Gehäuses oder Gerätes in dessen Innenraum. Bei einem sich aufheizenden Gehäuse oder Gerät hingegen durchläuft ein Teil der sich in seinem Innenraum ausdehnenden Luft den Lüftungsweg im Druckausgleichsetikett in umgekehrter Richtung und gelangt so durch die Lüftungskanäle ins Freie.

Auch im ersten Fall, wenn das innere Ende der Lüftungskanäle zumindest bereichsweise von der Membran bedeckt ist, ist die zweite Folie - nunmehr infolge des dazwischen liegenden Randes der Membranfolie - von der ersten Folie beabstandet; und von den inneren Enden der Lüftungskanäle aus führt der weitere Lüftungsweg - durch den Zwischenraum zwischen dem äußeren Rand der Membranfolie und der Unterseite der zweiten Folie hindurch - ebenfalls weiter bis zur Mitte der Oberseite der Membranfolie.

Der Lüftungskanal 7 bzw. die Anzahl von Lüftungskanälen 7 reicht daher nicht bis an die zentrale Aussparung 6 heran, sondern letztere ist durch einen inneren Folienbereich der ersten Folie 1 vollständig umgeben und besitzt daher keinen seitlichen Durchlass zu den Lüftungskanälen 7 oder gar nach außen. Der die Aussparung 6 umgebende Folienbereich umfasst somit insbesondere die zur Trennung von den Lüftungskanälen 7 vorgesehenen Folienbereiche 8. Die Folienbereiche 8 dienen daher als Barrieren oder Brückenbereiche und werden - ebenso wie die Aussparung 6 - mit einer Membranfolie 3 überklebt und abgedichtet (vgl. Figuren 2A bis 2C). Die Lüftungskanäle 7 hingegen verlaufen seitlich außerhalb der Membranfolie und werden daher über den größten Teil ihrer Kanallänge direkt durch eine obere, zweite Folie abgedeckt.

Figur 1A zeigt zugleich zwei alternative Ausführungsformen hinsichtlich der äußeren Kanalenden 12, je nachdem, wo der Außenrand der ersten Folie 1 verläuft. Bei der einen Ausführungsform ist der Außenrand durch R1 gebildet, d.h. er verläuft außerhalb und beabstandet von dem äußeren Ende 12 der Lüftungskanäle 7. Die Lüftungskanäle 7 in der ersten Folie 1 reichen hierbei nicht bis an deren Außenrand R1 heran. Die später aufzuklebende zweite Folie wird bei dieser Ausführungsform mit eigenen Kanalaustrittsöffnungen versehen, welche über den äußeren Kanalenden 12 der Lüftungskanäle 7 der ersten Folie 1 zu liegen kommen.

Bei der alternativen Ausführungsform ebenfalls gemäß Figur 1A wird der Außenrand der ersten Folie 1 nicht durch R1, sondern durch R1' (gestrichelt dargestellt) gebildet. In diesem Fall enden die Lüftungskanäle 7 an dem mit R1' gekennzeichneten Außenrand bzw. Folienrand, d.h. führen direkt am Etikettenrand ins Freie. Hierbei sind keine Kanalaustrittsöffnungen in einer oberen, zweiten Folie mehr erforderlich, sondern das äußere Ende 12 jedes Lüftungskanals 7 liegt am Außenrand der ersten Folie 1.

Die obigen Ausführungen gelten ebenso für Figur 1B, die eine erste Folie 1 mit kreisrunder Außenkontur zeigt, sowie für Figur 1C, die eine erste Folie 1 mit länglichem Foliengrundriss, beispielsweise mit einer lateralen Haupterstreckung zeigt. Die gezeigten Abmessungen in allen Figuren dieser Anmeldungen sind lediglich exemplarisch und oft vergrößert dargestellt; auch die Proportionen sind nicht maßstäblich. Die Bezugszeichen gelten für alle Figuren einheitlich.

In Figur 1C ist zur Vermeidung von Wiederholungen der Foliengrundriss nur noch für diejenige Ausführungsform gezeigt, bei der die äußeren Enden 12 der Lüftungskanäle 7 bis an den äußeren, d.h. umfangsseitigen Folienrand R1' heranreichen. Die erste Folie 1 kann beispielsweise einen ovalen, polygonalen oder beliebigen sonstigen Außenumriss besitzen.

Ungeachtet der gezeigten beispielhaften Gestaltungsmuster ist ebenso denkbar, lediglich einen einzigen Lüftungskanal 7 oder eine andere Anzahl von Lüftungskanälen 7 in der ersten Folie 1 vorzusehen bzw. zu stanzen.

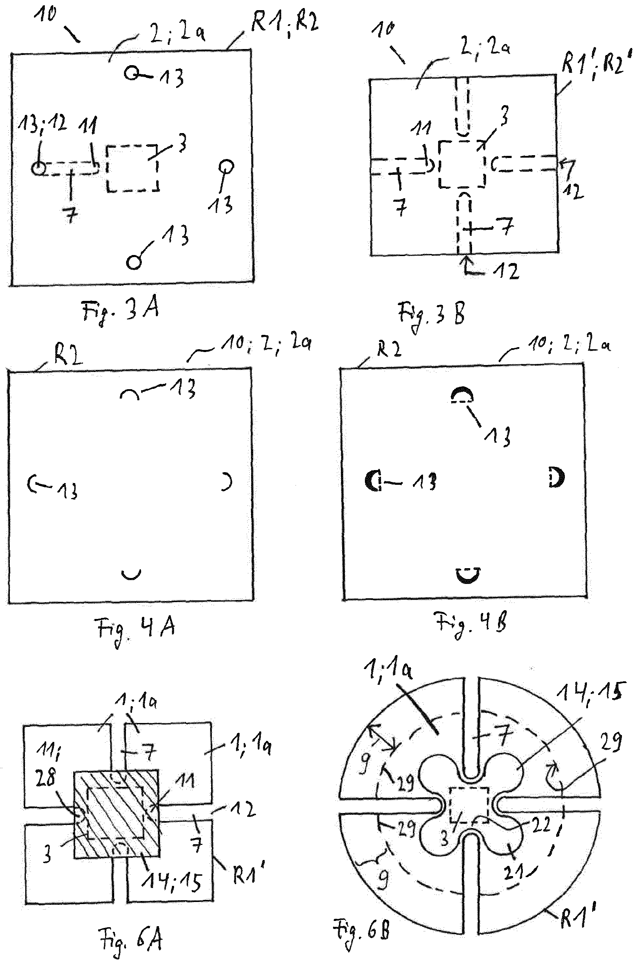

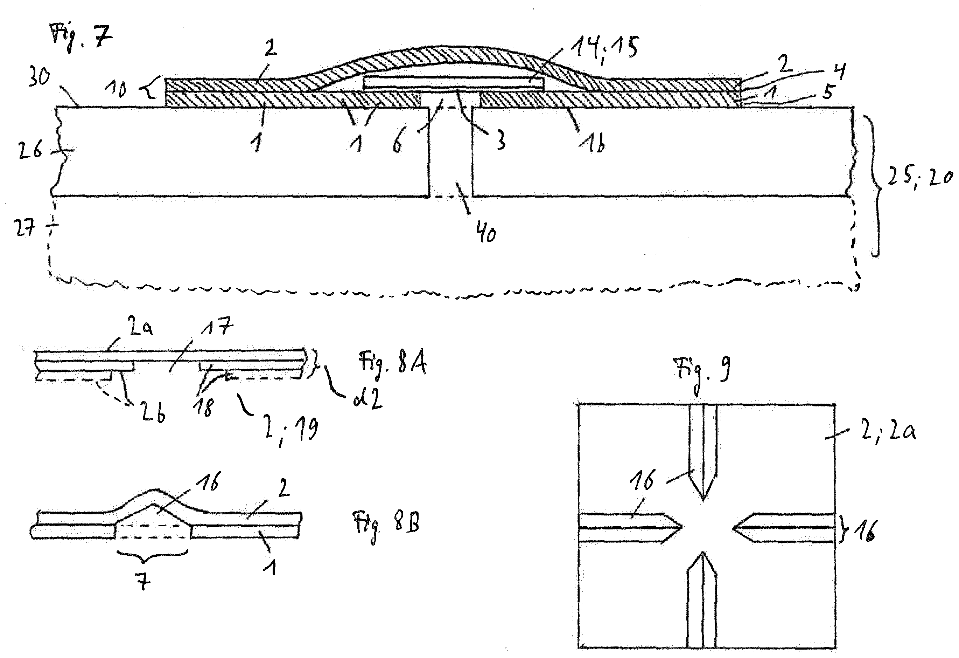

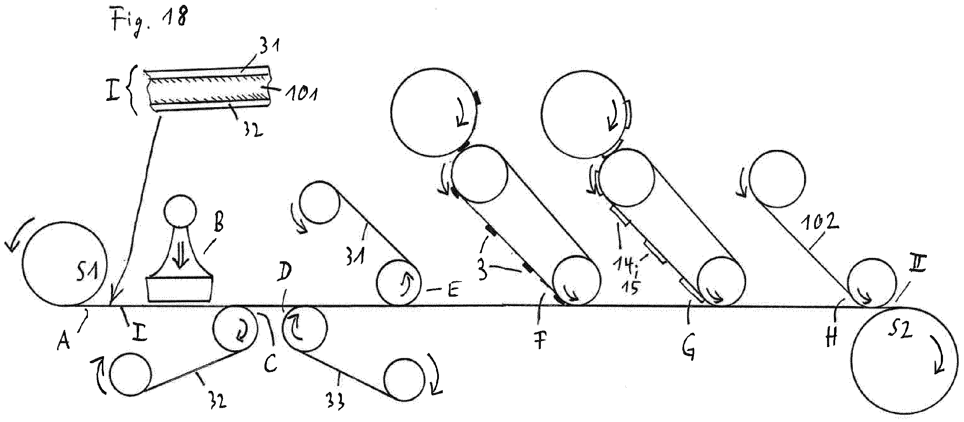

In den Figuren 1A bis 1C mag dasjenige Gestaltungsmuster mit dem Rand R1' - zumal als Stanzmuster - für die Form der ersten Folie 1 auf den ersten Blick wenig stabil erscheinen (ebenso wie später in Figur 6A oder 6B), weil die äußeren Folienbereiche der ersten Folie 1 nur durch die als Brückenbereiche dienenden inneren Folienbereiche 8 zwischen der Aussparung 6 und den Lüftungskanälen 7 zusammengehalten werden. Die in den Figuren 1A bis 1C gezeigte Oberseite 1a der ersten Folie 1 ist jedoch durch eine obere, zweite Folie 2 stabilisiert (Figuren 3A bis 4B). Zudem werden die äußeren Bereiche der ersten Folie 1 bereits bei der Herstellung des gesamten Etiketts unterseitig (und vor dem Aufkleben der oberen, zweiten Folie auch oberseitig) durch eine entsprechende Trägerfolie - typischerweise silikonisiertes bzw. antihaftbeschichtetes Papier oder eine silikonisierte bzw. antihaftbeschichtete Polymerfolie - in Position gehalten (Figur 18 und Ansprüche 13 bis 15). Auch nach dem Aufkleben des fertigen Gesamtetiketts, wenn die erste Folie 1 mit ihrer klebenden Unterseite direkt auf eine Gehäuseoberfläche geklebt ist (Figuren 5A, 5B und 7), bleiben die zwischen den Lüftungskanälen 7 angeordneten Folienbereiche der ersten Folie 1 jeweils von oben und unten gegen Verrutschen oder sonstige Deformationen gesichert.

Zwischen der ersten Folie 1 und der (in den Figuren 1A bis 2C noch nicht dargestellten) zweiten Folie 2 ist eine Membranfolie 3 angeordnet, die in den Figuren 2A bis 2C auf der Oberseite 1a der ersten Folie 1 abgebildet ist. Die Membranfolie 3 bedeckt mit ihrer Unterseite die Oberseite 1a der ersten Folie 1, und zwar im Bereich der Aussparung 6 und der inneren, zwischen ihr und den Lüftungskanälen 7 angeordneten inneren Folienbereiche 8. Die Lüftungskanäle 7 hingegen werden von der Membranfolie 3 nicht bedeckt. Vorzugsweise ist die erste Folie 1 beidseitig klebend; dieses Merkmal ist in Verbindung mit jeder beliebigen Ausführungsform gemäß den Figuren, Ansprüchen oder Beschreibungsteilen dieser Anmeldung kombinierbar. Die Membranfolie 3 dichtet die Aussparung 6 feuchtigkeitsdicht ab, ist aber für Luft durchlässig und erlaubt daher einen Druckausgleich eines Gehäuses an seiner mit dem Etikett überklebten Druckausgleichsöffnung, ohne dass Feuchtigkeit in das Gehäuseinnere eindringen kann, mit der Außenumgebung des Gehäuses.

Der Lüftungsweg L zwischen den inneren Enden 11 der Lüftungskanäle 7 und der Oberseite der Membranfolie 3, der später noch anhand der Figuren 3A bis 3C erläutert werden wird, lässt sich dadurch erweitern, dass - wie in den Figuren 2B und 2C exemplarisch dargestellt - die Form der Membranfolie 3 gegenüber einem kreisförmigen oder polygonalen Umriss (vgl. Figur 2A) abgewandelt wird. So zeigen die Figuren 2B und 2C, dass die Membranfolie 3 seitliche Ausbuchtungen 21, d.h. Vorsprünge aufweisen kann. Zwischen den Ausbuchtungen 21 sind Einschnürungen 22 vorhanden, wo die Membranfolie 3 eine kleinere seitliche Ausdehnung besitzt als im Bereich der Ausbuchtungen 21. Die seitlichen Ausbuchtungen 21 der Membranfolie 3 kommen mit Flügelbereichen (hier Quadranten der Folienfläche), die jeweils zwischen einander benachbarten Lüftungskanäle 7 der ersten Folie 1 liegen, zur Deckung. Dementsprechend kommen die Einschnürungen 22 mit den als Materialbrücken dienenden Folienbereichen 8, die zwischen der zentralen Aussparung 6 und den Lüftungskanälen 7 der ersten Folie 1 liegen, zur Deckung oder überlappen mit den Folienbereichen 8 zumindest bereichsweise. Weitere Maßnahmen zur Aufweitung des Lüftungsweges L werden weiter unten beschrieben.

Die Figuren 3A und 3B zeigen das fertige Druckausgleichsetikett 10 von oben, d.h. als Draufsicht auf die Außenseite 2a der oberen, d.h. zweiten Folie 2. Die Membranfolie reicht nicht bis an die Außenränder der Folien 1, 2 heran, sondern ist von diesen beabstandet, vorzugsweise um jeweils mindestens 1,0 mm. Die Außenkontur der ersten Folie 1 sowie der zweiten Folie 2 (und somit auch des Etiketts 10 insgesamt) braucht jedoch nicht wie dargestellt quadratisch zu sein.

Figur 3A zeigt die Oberseite 2a der zweiten Folie 2 für den Fall, dass in den Figuren 1A bzw. 2A der Außenrand der ersten Folie 1 durch R1 gegeben ist, d.h. seitlich außerhalb der äußeren Enden 12 der Lüftungskanäle 7 liegt. Figur 3B hingegen zeigt die Oberseite 2a der zweiten Folie 2 für den Fall, dass in den Figuren 1A bzw. 2A der Außenrand der ersten Folie 1 durch R1' gegeben ist und die Lüftungskanäle 7 am Außenrand R1' der ersten Folie 1 enden.

Die in den Figuren 3A und 3B gezeigten Abbildungen zeigen somit die Oberseite des jeweiligen fertigen Druckausgleichsetiketts 10. Die Außenkontur der zweiten Folie 2 entspricht in den Figuren 3A und 3B derjenigen der ersten Folie 1. Dies ist jedoch keine Notwendigkeit; insbesondere kann die zweite Folie kleiner, d.h. seitlich weniger ausgedehnt sein als die erste. Unterseitig ist die erste Folie 1 vorzugsweise ganzflächig klebend. Vorzugsweise ist sie auch oberseitig, d.h. zur zweiten Folie hin ganzflächig klebend bzw. ganzflächig mit einer oberseitigen Klebeschicht bedeckt. Die Folie ist somit beidseitig ganzflächig klebend (dies gilt vorzugsweise in Verbindung mit jeder beliebigen Ausführungsform dieser Anmeldung), was eine besonders einfache Herstellung aus Rollenware ermöglicht.

In Figur 3A ist erkennbar, dass die zweite Folie 2 dort, wo unter ihr die äußeren Kanalenden 12 der Lüftungskanäle 7 liegen, Kanalaustrittsöffnungen 13 aufweist, welche die Lüftungskanäle 7 der ersten Folie 1 mit der Außenumgebung des Druckaustauschetiketts 10 bzw. des damit versehenen Gehäuses verbinden. In Figur 3A ist der Verlauf nur eines der vier Lüftungskanäle 7 unterhalb der zweiten Folie 2 gestrichelt angedeutet; ebenso der Umriss der Membranfolie 3. Die Oberseite der Membranfolie 3 ist der zweiten Folie 2 zugewandt. Durch die Unterseite der Membranfolie 3 werden die Aussparung 6 und die diese umgebenden Folienbereiche 8 der unteren, d.h. ersten Folie 1 abdeckt. Dadurch ist die Aussparung 6 von oben her feuchtigkeitsdicht, aber luftdurchlässig überdeckt, was den gewünschten Druckausgleich ermöglicht, aber den Innenraum des Gegenstandes vor eindringender Feuchtigkeit schützt. Abgesehen von den Kanalaustrittsöffnungen 13 ist die zweite Folie 2 vollflächig ausgebildet, d.h. sie ist frei von sonstigen Öffnungen, Unterbrechungen oder Aussparungen.

Gemäß Figur 3B besitzt die zweite Folie 2 sogar keinerlei Aussparungen, denn dort bilden die äußeren Enden 12 der Lüftungskanäle 7, die mit dem Außenrand R1' der unteren, ersten Folie 1 zusammenfallen, zugleich die Kanalaustrittsöffnungen des gesamten Druckausgleichsetiketts 10.

Im Druckausgleichsetikett 10 führt der Lüftungsweg daher jeweils von außen durch die Lüftungskanäle 7 in der unteren, d.h. ersten Folie 1, von deren inneren Enden 11 aus weiter zur Flächenmitte des Etiketts - und zwar in Höhe zwischen der Oberseite der Membranfolie 3 und der Unterseite der zweiten Folie 2 - und von dort schließlich durch die Membran und die Aussparung 6 hindurch und danach in den etikettierten Gegenstand hinein. Der Bereich der Flächenüberlappung der Membranfolie 3 mit der zweiten Folie 2 ist nichtklebend ausgebildet. Vorzugsweise ist die gesamte zweite Folie 2 nichtklebend; weder obernoch unterseitig.

Da die von der zweiten Folie 2 überklebte Membranfolie 3 eine Erhöhung gegenüber der ersten Folie 1 darstellt, wölbt sich die zweite Folie über der Membranfolie 3 leicht auf. Zudem ist - selbst bei ganzflächig klebender Oberseite 1a der ersten Folie 1 - wegen der Schichtdicke der Membranfolie 3 keine bis an den Außenrand der Membranfolie 3 heranreichende Klebeverbindung der ersten Folie mit der zweiten Folie realisiert. Stattdessen umläuft der in dieser Anmeldung als "Auflageflächenbereich" bezeichnete Flächenbereich, in dem die erste und die zweite Folie 1, 2 direkt aufeinander aufliegen (und allenfalls durch eine dünne Klebeschicht konstanter Schichtdicke voneinander getrennt sind), zwar die Membranfolie 3, ist aber von dem Außenrand der Membranfolie 3 (wegen des Höhenunterschiedes zwischen der Membranfolie 3 und der ersten Folie 1) in seitlicher Richtung beabstandet. Dieser seitliche Abstand des Auflageflächenbereichs der Folien 1, 2 zur Membranfolie 3 stellt den Lüftungsweg dar im Bereich zwischen den inneren Enden 11 der Lüftungskanäle 7 der ersten Folie 1 und der Oberseite 3a der Membranfolie 3 (genauer: dem Zwischenraum zwischen der Oberseite 3a der Membranfolie 3 und der Unterseite der zweiten Folie 2). Von dort führt der Lüftungsweg weiter durch die Membranfolie 3 hindurch und durch die Aussparung 6 der ersten Folie 1 bis zur Druckausgleichsöffnung des mit dem Etikett 10 beklebten Gehäuses. Je nachdem, ob im überklebten Gehäuse tendenziell Über- oder Unterdruck herrscht, strömt Luft durch das Druckausgleichsetikett 10 hindurch aus dem damit versehenen Gehäuse heraus oder in das Gehäuse hinein.

Die Figuren 4A und 4B zeigen zwei zu Figur 3A alternative Abwandlungen hinsichtlich der Ausbildung der Kanalaustrittsöffnungen 13 in der zweiten Folie 2, deren Oberseite 2a ebenfalls in den Figuren 4A und 4B dargestellt ist. Während in Figur 3A die Kanalaustrittsöffnungen 13 in Form von beispielsweise kreisförmigen oder anderweitigen Aussparungen gestattet sind, sind gemäß Figur 4A lediglich schlitzförmige Durchbrechungen der zweiten Folie 2, etwa in Form von Innenstanzungen, als Kanalaustrittsöffnungen 13 vorgesehen. Die Innenstanzungen sind vorzugsweise kurvenförmig bzw. gebogen, beispielsweise halbkreisförmig, V-förmig, U-förmig oder in sonstiger Weise gestaltet. Figur 4B zeigt eine Abwandlung, bei der die Kanalaustrittsöffnungen 13 durch hochgebogene oder jedenfalls aufbiegbare Laschen realisiert sind. Dazu wird beispielsweise eine Stanzung wie in Figur 4A vorgesehen (ggfs. mit einer zusätzlichen Knicklinie, die in Figur 4B gestrichelt dargestellt ist) und im Rahmen des Herstellungsprozesses zu einer beispielsweise halbkreisförmigen Lasche hochgebogen. Die genaue Form der Stanzung oder Lasche in den Figuren 4A und 4B ist lediglich beispielhaft. Mit Hilfe solcher schlitzförmiger Innenstanzungen bzw. Stanzlinien (Figur 4A) und/oder nur um einen gewissen Winkel aufgebogener Laschen (Figur 4B) ist das unter der Kanalaustrittsöffnung 13 befindliche äußere Ende 12 des jeweiligen Lüftungskanals 7 der ersten Folie 1 äußeren Einflüssen wie beispielsweise einem Hochdruckreiniger oder Dampfstrahlreinigungsgerät weniger stark ausgesetzt.

Die Figuren 5A und 5B zeigen beispielhafte Querschnittsansichten eines mit einem Druckausgleichsetikett 10 gemäß dieser Anmeldung versehenen Gegenstand 20, beispielsweise einem Gehäuse 25. Es ist jeweils nur eine Gehäusewand 26 und ein Teil des dahinter befindlichen Innenraums 27 des Gehäuses dargestellt. Auf der Außenseite bzw. äußeren Oberfläche 30 der Gehäusewand 26 befindet sich das Druckausgleichsetikett 10, und zwar in einer geeigneten Position, um die Druckausgleichsöffnung 40 des Gehäuses 25 bzw. ihrer Gehäusewand 26 luftdurchlässig, aber feuchtigkeitsundurchlässig zu verschließen. Hierzu wird das Druckausgleichsetikett 10 in den Figuren 5A und 5B jeweils so auf die Oberfläche 30 geklebt, dass die Aussparung 6 der ersten Folie 1 mit der Druckausgleichsöffnung 40 des Gehäuses 25 oder des sonstigen Gegenstandes 20 zur Deckung kommt. Dadurch wird die Druckausgleichsöffnung 40 durch denjenigen Teil der Unterseite 3b der Membranfolie 3 überdeckt, der die Aussparung 6 der ersten Folie überspannt und ringsherum an den Folienbereichen 8 angeklebt ist. Die Membran 3 ist für Gase, insbesondere für Luft durchlässig; auf ihrer Oberseite 3a führt der weitere Lüftungsweg L zunächst in seitlicher Richtung über den Rand der Membranfolie 3 hinaus und von dort in den jeweiligen Lüftungskanal 7 der ersten Folie 1. Zur Verdeutlichung dieses Lüftungsweges L zeigen die Figuren 5A und 5B eine Schnittansicht durch in Höhe der Aussparung 6 und je zweier Lüftungskanäle 7. Hinsichtlich der Gestaltung des äußeren Endes 12 der Lüftungskanäle 7 basiert Figur 5A auf Figur 3B, der zufolge die Lüftungskanäle 7 bis zum Außenrand R1' der ersten Folie reichen und dort seitlich ins Freie führen. Figur 5B hingegen basiert diesbezüglich auf Figur 3A, gemäß der die äußeren Enden 12 der Lüftungskanäle 7 vom Außenrand R1 der ersten Folie 1 beabstandet sind und die zweite Folie 2 über ihnen ins Freie führende Kanalaustrittsöffnungen 13 aufweist. Selbstverständlich ist Figur 5B auch gemäß den Figuren 4A und Figur 4B abwandelbar und selbstverständlich sind die Figuren 5A und 5B hinsichtlich aller sonstigen Einzelheiten sowie Merkmalskombinationen mit jeder anderen Figur oder sonstigen Ausführungsform dieser Anmeldung kombinierbar. Beispielsweise kann die Außenkontur der Druckausgleichsetiketten 10 in den Figuren 5A und 5B jede beliebige andere Form statt quadratisch annehmen, jede beliebige sonstige Anzahl von Lüftungskanälen 7 aufweisen, und/oder die Außenkontur der Membranfolie 3 kann beliebig abgewandelt werden.

Gemäß den Figuren 5A und 5B führt der Lüftungsweg L außerhalb der Membranfolie bzw. außerhalb der durch diese abgedeckten Aussparung 6 wieder zurück in die Ebene der ersten Folie 1; deren Lüftungskanäle 7 sind jeweils durch die als Brückenbereiche dienenden Materialstege bzw. Folienbereiche 8 von der Aussparung 6 getrennt. Die Folienbereiche 8 versperren somit einen direkten Durchgang zwischen der Aussparung 6 und jedem der Anzahl von Lüftungskanälen 7; die Membranfolie kann somit nur durchquert, aber nicht umgangen werden.

In den Figuren 5A und 5B ist jeweils auch der Kontaktflächen- bzw. Auflageflächenbereichs 9 noch besser erkennbar, in dem die obere, zweite Folie 2 mit ihrer Unterseite 2b auf der Oberseite 1a der ersten Folie 1 aufliegt. Dieser Auflageflächenbereich, in dem sich beide Folien 1, 2 berühren (und beispielsweise miteinander verschweißt oder verklebt sind), befindet sich ausschließlich außerhalb der Grundfläche der Membranfolie 3 und nimmt zudem auch außerhalb der Membranfolie 3 nur eine Grundfläche ein, die von dem Außenumfang der Membranfolie 3 beabstandet ist. Dies gilt insbesondere im Bereich der inneren Kanalenden 11 der Lüftungskanäle 7, von wo aus eine ungehinderte Luftbewegung hin zur Mitte der Oberseite der Membranfolie 3 gewährleistet sein muss.

Im einfachsten Fall, wie in den Figuren 5A und 5B gezeigt, wird der Höhenunterschied zwischen der Membranfolie 3 und der ersten Folie 1 ausgenutzt, um einen ausreichenden Abstand (ringsherum um die Membranfolie 3 herum) zwischen der Membranfolie 3 und dem Auflageflächenbereich 9, d.h. dem Verbindungsbereich der Folien 1 und 2 zu gewährleisten. Der zwischen dem Auflageflächenbereich 9 und der Membranfolie 3 bestehende seitliche Abstand ermöglicht, dass Luft, die durch die Membranfolie in den Zwischenraum zwischen ihr und der zweiten Folie 2 gelangt, weiter bis zum inneren Kanalende 11 des jeweiligen Lüftungskanals 7 und von dort aus durch den Kanal ins Freie strömen kann. Um einen ausreichenden Querschnitt des Lüftungsweges L im Bereich über den inneren Kanalenden 11 der Lüftungskanäle 7 zu gewährleisten, kann beispielsweise die Dicke bzw. Schichtdicke der Membranfolie 3 und/oder ihre Grundfläche, d.h. ihre Außenkontur in geeigneter Weise gewählt werden. Beispielsweise kann die Membranfolie 3 in Bereichen zwischen jeweils zwei einander benachbarten Lüftungskanälen 7, wie in Figur 2B und 2C dargestellt, Ausbuchtungen 21 seitlich nach außen hin aufweisen. Aber auch bei einem quadratischen Zuschnitt der Membranfolie 3 reichen die Eckbereiche weiter seitlich vom Mittelpunkt der Aussparung 6 nach außen als die Kantenmitten der Membran. Daher sind auch in den Figuren 5A und 5B die in der Zeichenebene links und rechts dargestellten Außenränder der Membranfolie 3 nicht in direktem Kontakt mit der Unterseite 2b der zweiten Folie 2, sondern von dieser nach oben hin beabstandet. Die Schichtdicken der ersten und zweiten Folie sowie der Membranfolie sind in den Figuren 5A und 5B zur besseren Erkennbarkeit übertrieben groß dargestellt; die Schichtdicken und Schichtdickenverhältnisse sind nicht maßstäblich. Sie können geeignet gewählt werden, insbesondere um eine ausreichende Mittenwölbung der zweiten Folie 2 über der Membranfolie 3 zu gewährleisten, beispielsweise durch die Schichtdicke der Membranfolie 3 alleine. Aber auch durch die Geometrie bzw. Grundflächenform der Membranfolie 3 lässt sich die Membrangrundfläche geeignet gestalten, beispielsweise mit Ausbuchtungen 21 wie in Figur 2B entlang der Diagonalrichtungen zwischen je zwei Lüftungskanälen 7.

Zur weiteren Aufweitung des Lüftungsweges L zwischen den Lüftungskanälen 7 und dem Zwischenraum oberhalb der Membranoberseite 3a kann, wie in Figur 6A und 6B gezeigt, ein zusätzlicher Abstandhalter 14 auf die Membranfolie 3 aufgebracht werden. So zeigt Figur 6A beispielsweise eine Materiallage 15, die zumindest die Membranfolie 3 und optional auch die inneren Enden 11 der Lüftungskanäle 7 überdeckt. Die Materiallage 15 ist selbst luftdurchlässig und stellt beispielsweise ein Vlies oder sonstiges Gewebe dar. Sie dient als Abstandhalter 14 zwischen der Membranfolie 3 und der zweiten Folie 2 (die noch auf die Anordnung in Figur 6A zu kleben ist, um das fertige Druckausgleichsetikett 10 zu erhalten). Hinsichtlich der äußeren Enden 12 der Lüftungskanäle 7 basiert Figur 6A (und Figur 6B für den Fall eines kreisrunden Etiketts) übrigens auf Figur 3B; d.h. die zweite Folie 2 ist ohne jegliche Öffnungen, Durchstanzungen oder sonstige Unterbrechungen ausgebildet.

In Figur 6A und 6B sind die durch die Kanäle 7 getrennten, nur über die Folienbereiche bzw. Brückenbereiche 8 (vgl. Figur 1A, 2A) zusammenhängenden Außenbereiche der ersten Folie 1 einzeln noch besser erkennbar; Gleiches gilt für Figur 6B. Während in Figur 6A der Abstandhalter 14 quadratisch geformt ist, besitzt er gemäß Figur 6B seitliche Ausbuchtungen 21 (und dazwischen Einschnürungen 22) ähnlicher Form wie bei der Membranfolie 3 in Figur 2B. Es können ferner sowohl die Membranfolie 3 als auch der Abstandhalter 14 die gleiche Grundfläche bzw. Außenkontur besitzen; ggf. mit diesen oder ähnlichen Ausbuchtungen 21. Der Abstandhalter gemäß Figur 6A oder 6B vergrößert die Aufwölbung der zweiten Folie 2 über der Membran 3 und vor allem an den an diese angrenzenden Bereichen der ersten Folie 1 und bewirkt so, dass von der Etikettenmitte aus die inneren Enden 11 der Lüftungskanäle 7 von der Etikettenmitte her leichter zugänglich werden. Dabei kann die Luft auch in lateraler Richtung durch das Gewebe (Vlies etc.) der als Abstandhalter 14 dienenden Materiallage 15 strömen. Im Übrigen lässt sich eine Membranfolie 3 verwenden, die bereits mit einer Vlieslage oder einer sonstigen luftdurchlässigen Materiallage einseitig bedeckt und verbunden ist. Infolge der höheren Aufwölbung der zweiten Folie 2 ist, wie exemplarisch in Figur 6B dargestellt, der Innenrand 29 des Auflageflächenbereichs 9 in radialer Richtung bzw. lateraler Richtung deutlich weiter von der Membran 3 bzw. der Etikettenmitte entfernt; der Lüftungsweg innerhalb des Etiketts hat sich verbreitert. Die obere, zweite Folie 2 ist in Figur 6B noch nicht dargestellt, ist aber bei der Fertigstellung des Etiketts von oben auf die in Figur 6B dargestellte Anordnung aufzubringen, z.B. durch Aufkaschieren. Die zweite Folie 2 liegt danach nur in einem (bei dieser Ausführungsform etwa kreisringförmigen) Randbereich, nämlich dem Auflageflächenbereich 9, unmittelbar auf der ersten Folie 1 auf.

Figur 7 zeigt eine schematische Querschnittsansicht einer gegenüber Figur 6A oder Figur 6B leicht abgewandelten Ausführungsform. Gemäß Figur 7 ist wie in Figur 6A oder 6B eine zusätzliche Materiallage 15 bzw. ein Abstandhalter 14 auf der Membranfolie 3 vorgesehen. Dadurch erhöht sich die mittige Aufwölbung bzw. Mittenwölbung der zweiten Folie 2 über der Membranfolie 3 und somit ihr gegenseitiger vertikaler Abstand voneinander. Stärker noch als bei der Membran 3 ist in dem Material der Materiallage 15 (ein Vlies, Filz, Stoff oder sonstiges Gewebe) auch eine Luftbewegung bzw. ein Lufttransport innerhalb dieses Materials in seitlicher Richtung möglich. Die Materiallage 15 stellt daher kein Hindernis für einen Druckausgleich dar, sondern vergrößert den Querschnitt des Lüftungsweges. Gegenüber Figur 6A oder 6B besteht in Figur 7 die Abwandlung darin, dass der Abstandhalter 14 die gleiche Grundfläche besitzt wie die Membranfolie 3. Die Darstellung in Figur 7 wurde allerdings so gewählt, dass zwar die Aussparung 6, jedoch nicht die Lüftungskanäle 7 in der Zeichenebene liegen. Beispielsweise verläuft die Zeichenebene in Figur 7 diagonal durch die Draufsicht auf Figur 6A oder 6B. Wie in Figur 6A oder 6B kann der Abstandhalter 14 eine andere, insbesondere größere Grundfläche besitzen als die Membran 3. Die Membran 3 soll übrigens die inneren Kanalenden 11 der Lüftungskanäle 7 in der ersten Folie 1 nicht überdecken. Deren Überdeckung durch das luftdurchlässige Material des Abstandhalters 14 ist hingegen unschädlich. Vorzugsweise besitzt der Abstandhalter 14 (oder die Membran oder beide von ihnen) seitliche Ausbuchtungen 21 in Bereichen zwischen den Lüftungskanälen, beispielsweise ähnlich der kleeblattartigen Grundrissstruktur der Figuren 2B, 6B oder 2C. Infolge der um 45° verdrehten Schnittebene in Figur 7 sind die Lüftungskanäle 7 dort nicht zu sehen. Dafür ist der Auflageflächenbereich bzw. Kontaktflächenbereich, der in Figur 5A und 5B mit dem Bezugszeichen 9 gekennzeichnet ist, in Figur 7 als Grenzfläche zwischen den beiden Folien 1, 2 (in Figur 7 jeweils schraffiert dargestellt) noch besser erkennbar. Durch den Abstandhalter 14 kann im mittleren Etikettenbereich ein großer Abstand zwischen den Folien 2 und 3 und dadurch auch ein größerer seitlicher Abstand zwischen dem Außenrand der Membranfolie 3 und dem Innenrand 29 des Kontaktflächenbereichs 9 (vgl. auch Figur 6B) erreicht, d.h. ein leichterer und/oder schnellerer Luftdurchzug bzw. Druckausgleich erreicht werden. Die äußeren Enden der in Figur 7 orientierungsbedingt nicht erkennbaren Lüftungskanäle können wahlweise gemäß den Alternativen der Figuren 3A oder 3B gewählt sein; d.h. die Kanäle können zur Seite hin oder alternativ durch die zweite Folie 2 hindurch ins Freie geführt sein. Ansonsten sind in Figur 7 noch Klebeschichten beiderseits der ersten Folie 1 mit den Bezugszeichen 4 und 5 angedeutet. Vorzugsweise ist die erste Folie 1 eine beidseitig vollflächig klebende bzw. bereits mit Klebeschichten 4 bzw. 5 versehene Folie. Mittels der unterseitigen Klebeschicht 5 wird die erste Folie 1 beim Verspenden des fertigen Druckausgleichsetiketts 10 auf die Oberfläche 30 eines Gegenstandes 20, beispielsweise eines Gehäuses 25 geklebt, wobei die von der Membran 3 bedeckte Aussparung 6 über der Druckausgleichsöffnung 40 der Gehäusewand 26 zu liegen kommt. Zugleich werden die bis dahin nach unten offenen Lüftungskanäle 7 in der ersten Folie 1 des Druckausgleichsetiketts 10 von unten verschlossen, nämlich durch die beklebte Oberfläche 30 des Gegenstandes selbst. Eine eigene, zusätzliche Folie zum Verschließen der Kanäle von unten oder zum Ausbilden von Lüftungskanälen zwischen der ersten und der zweiten Folie ist somit nicht mehr erforderlich. Die Druckausgleichsetiketten 10 gemäß dieser Anmeldung sind somit mechanisch besonders robust, zugleich aber sehr einfach und kostengünstig in der Herstellung.

Die zweite Folie 2 in Figur 7 ist (wie in den übrigen Figuren auch) eine beidseitig nichtklebende Folie. Die Klebeschicht 4 ist somit eine oberseitige Klebeschicht der ersten Folie 1. Sie könnte statt vollflächig auch lediglich bereichsweise in einigen Flächenbereichen der ersten Folie 1 vorgesehen sein.

Die Figuren 8A und 8B zeigen zwei Ausführungsbeispiele hinsichtlich der Form der zweiten Folie 2, die auch auf alle übrigen Figuren dieser Anmeldung übertragen werden können. Gemäß Figur 8A ist die zweite Folie 2 eine Verbundfolie 19, die beispielsweise zwei oder noch mehr Teilschichten 18 aufweist. Im Bereich oberhalb der Lüftungskanäle 7, insbesondere über deren innerem Kanalende 11, kann eine untere Teilschicht 18 der zweiten oberen Verbundfolie 19 ausgespart sein, d.h. die zweite Folie kann dort dünner sein, um den dortigen Lüftungsweg zu verbreitern. Es können auch zwei von drei Teilschichten 18 mit entsprechenden, ggfs. unterschiedlich breiten Ausnehmungen 17 vorgesehen sein. Gemäß Figur 8B kann anstelle solcher Ausnehmungen 17 in einer oder mehreren Teilschichten auch eine Emporwölbung 16 über dem jeweiligen Lüftungskanal 7, insbesondere dessen inneren Kanalende 11 in der zweiten Folie vorhanden sein. Solche Emporwölbungen 16 sind beispielsweise durch Prägen der zweiten Folie 2 herstellbar, durch Anstanzen bzw. Ritzen und/oder Knicken, etwa in der Form, dass entlang der Flächenbereiche, in denen die erste Folie 1 die Lüftungskanäle 7 aufweist, die zweite Folie dachartig oder rinnenartig nach oben aufgerichtet ist.

Die gemäß Figur 8B angedeuteten Emporwölbungen 16 sind in Figur 9 in der Draufsicht auf die Oberseite 2a der zweiten Folie 2 dargestellt; ihre Positionen entsprechen denen der Lüftungskanäle 7 der ersten Folie 1. Diese Emporwölbungen 16 sind eher lokal ausgebildet im Vergleich zu der relativ großflächigen Aufwölbung der zweiten Folie insgesamt in ihrem mittleren Bereich, wo sie durch die Membranfolie 3 und ggf. auch durch die als Abstandhalter 14 dienende Materiallage 15 beim Aufkaschieren nach oben gedrückt wird.

Soweit diese Anmeldung übrigens quadratische oder ansonsten rechteckige Grundflächen von Druckausgleichsetiketten 10 oder deren Folien 1, 2 zeigt, können die Lüftungskanäle 7 der ersten Folie und/oder Emporwölbungen 16 oder unterseitige Aussparungen 17 der zweiten Folie 2 alternativ auch in Richtung der Diagonalen der jeweiligen Grundfläche verlaufen. Die Lüftungskanäle 7 erstrecken sich dann bis in die Ecken der Grundfläche oder jedenfalls dicht bis an diese heran, während im Bereich der Kantenmitten der Grundfläche weniger Folienmaterial (insbesondere der zweiten Folie) anfällt, welches sich beim Aufkaschieren den jeweiligen Verbiegungen durch die Auf- und Emporwölbungen widersetzen könnte.

Im Übrigen kann auch der Abstandhalter selbst während der Zukaschierung, d.h. wenn die erste und die zweite Folie 1, 2 miteinander verpresst werden, in die obere, zweite Folie eingeprägt werden. Bei der Zukaschierung bzw. dem Verpressen der beiden äußere Folien 1 und 2 gegeneinander können im Übrigen auch Kanalaustrittsöffnungen 13, wie sie in Figur 3A, 4A und 4B dargestellt sind, aufgestoßen, aufgedrückt oder in eine bestimmte Winkelstellung (beispielsweise von 45° gegenüber der Folienebene in Figur 4B) aufgerichtet werden. Hierzu können geeignete Dorne oder Vorsprünge eines Presswerkzeugs unter den Kanalaustrittsöffnungen 13 hochgedrückt werden (nicht dargestellt). Im Übrigen wird das Material für den Abstandhalter 14 bzw. für die Materiallage 15 (Vlies, Filz, Stoff, Gewebe etc.) so gewählt, dass ein ausreichender Lufttransport bzw. eine ausreichend hohe Gasdurchlässigkeit für einen wirksamen Druckausgleich gewährleistet ist - auch und gerade in lateraler Richtung seitlich durch das Vlies hindurch. Zugleich wird das Material so gewählt, dass es beim Verpressen mit der zweiten Folie 2 nicht über Gebühr gestaucht wird.

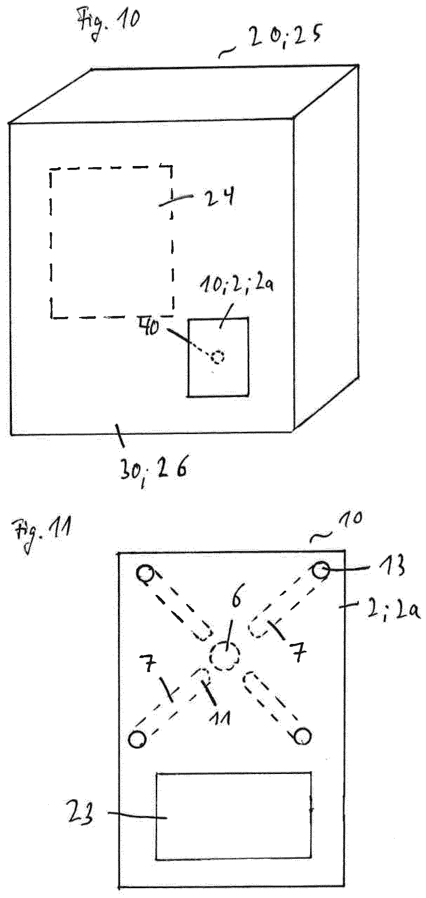

Figur 10 zeigt schematisch einen Gegenstand 20, der mit einem Druckausgleichsetikett 10 gemäß einer beliebigen Ausführungsform dieser Anmeldung versehen ist. Das Etikett 10 überklebt eine Oberfläche 30 des Gegenstandes 20 im Bereich um eine Druckausgleichsöffnung 40 herum. Dadurch ist ein Luftaustausch zwischen dem Innenraum des Gegenstandes 20 und der Umgebung möglich. Der Gegenstand ist beispielsweise ein Gehäuse 25 oder umfasst ein solches. Der Gegenstand ist beispielsweise eine Anlage, ein Gerät, ein Einzelteil oder eine elektrische oder elektronische Komponente 24, insbesondere für eine Maschine oder für ein Fahrzeug oder ein sonstiges Verkehrsmittel. Der Gegenstand kann als elektrische oder elektronische Komponente 24 beispielsweise eine Leiterplatte, ein elektrisches oder elektronisches Bauteil und/oder eine sonstige, elektrische Leistung verbrauchende Einheit aufweisen.

Figur 11 zeigt in vergrößerter Darstellung das Etikett 10, welches auf den Gegenstand in Figur 10 geklebt ist; es ist beispielsweise wie nachstehend anhand Figur 11 beschrieben ausgebildet oder alternativ gemäß einer beliebigen sonstigen Ausführungsform dieser Anmeldung gestaltet. Gemäß Figur 11 verlaufen die Lüftungskanäle 7, entlang derer im Etikett 10 der Lufttransport in seitlicher, d.h. lateraler Richtung (parallel zur Oberfläche 30 der Gehäusewand 26) verläuft, in diagonaler Richtung in Bezug auf die Kanten der hier rechteckige Etikettengrundfläche. Optional ist die Etikettenfläche in einer Richtung (in Figur 11 nach unten hin) verlängert, d.h. reicht entlang dieser Richtung von der Aussparung 6 für die Druckausgleichsöffnung 40 weiter weg als in Gegenrichtung und in die lateralen Richtungen senkrecht dazu. So lässt sich beispielsweise zusätzlich eine Beschriftung 23 (etwa durch Siebdruck) unterbringen und das Etikett außer als Druckausgleichsetikett 10 auch als Typenschild oder für eine sonstige Kennzeichnung des Gegenstandes 20 nutzen. Die alphanumerische oder sonstige Beschriftung 23 befindet sich vorzugsweise seitlich außerhalb der Membranfolie 3, d.h. sie ist überlappungsfrei zur Membranfolie 3 und - falls das Druckausgleichsetikett eine als Abstandshalter 14 dienende Materiallage 15 aufweist - auch überlappungsfrei zur Materiallage 15 angeordnet.

Sofern das Druckausgleichsetikett 10 gemäß einer beliebigen Figur oder sonstigen Ausführungsform dieser Anmeldung die äußeren Kanalausgänge für die Lüftungskanäle 7 seitlich am Etikettenrand bzw. der Etikettenrandfläche (statt auf der Oberseite der zweiten Folie) aufweisen soll, kann - ungeachtet des endgültigen Etikettenumrisses - die Fläche der Folienbahnen für die ersten und zweiten Folien 1, 2 zunächst größer als für die Etikettenfläche eigentlich nötig gewählt werden und der Etikettenrand somit zunächst außerhalb der Reichweite der Lüftungskanäle 7 gestanzt werden, beispielsweise entsprechend dem Außenrand R1 bzw. R2 in den Figuren 1A, 1B, 2A oder 2B. Anschließend kann durch einen (ggf. nochmaligen) Stanzvorgang die Etikettenfläche verkleinert werden, beispielsweise gemäß dem Rand R1' bzw. R2' (gestrichelt in Figur 1A, 1B, 2A, 2B und auch zugrundeliegend den Figuren 3B, 6A, 6B). Dadurch werden die Lüftungskanäle 7 an ihren äußeren Enden 12 angestanzt und so zur Seite hin geöffnet, wobei der umgebende Rand abfällt (randabfallendes Stanzen).

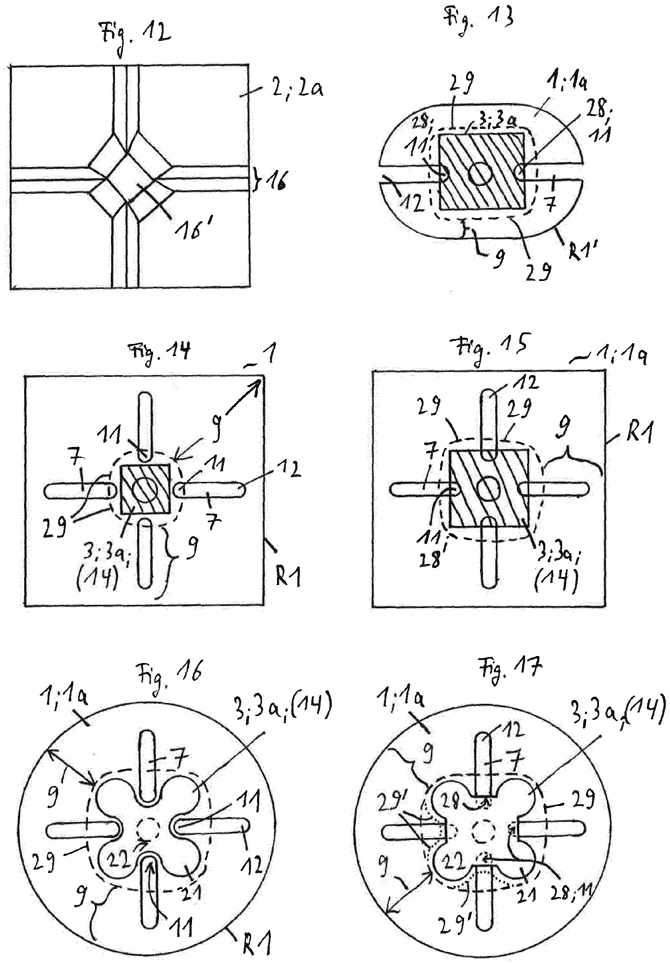

Figur 12 zeigt eine zu Figur 9 alternative Ausführungsform, bei der die Emporwölbungen 16 (Figur 8B) im Unterschied zu Figur 9 nicht nur entlang der Lüftungskanäle über diesen verlaufen, sondern auch über dem mittleren, die Membranfolie überdeckenden Bereich der Folie 2 ausgebildet sind; sie erstrecken sich bis zur Folienmitte und treffen dort aufeinander. Die Folie 2 weist somit eine Emporwölbung 16 auf, die zumindest auch im Mittenbereich der zweiten Folie 2 (d.h. im Flächenbereich über der Membranfolie 3) ausgebildet ist und sich bis zu den Flächenbereichen über den Lüftungskanälen 7, und zwar mindestens bis über deren innere Enden 11 erstreckt. Im Mittenbereich der zweiten Folie 2 kann beispielsweise eine verbreiterte Emporwölbung 16' bzw. ein verbreiterter Bereich von ihr ausgebildet sein.

Jegliche Emporwölbungen 16 bzw. 16' gemäß einer der Figuren 8B, 9 oder 12 können mit jeder beliebigen sonstigen Figur bzw. Ausführungsform dieser Anmeldung kombiniert werden. Die Emporwölbungen 16 bzw. 16' sind vorzugsweise durch Prägen hervortretend geformte Folienbereiche, d.h. sie treten auf der Oberseite 2a der zweiten Folie 2 (Prägefolie) nach oben hervor. Anstelle durch Prägen gebildeter Emporwölbungen 16 bzw. 16' gemäß den Figuren 8B, 9 oder 12 lassen sich derartige bereichsweisen Erhöhungen gegenüber der ersten Folie 1 alternativ auch durch unterseitige Ausnehmungen 17 in einer oder mehreren Teilschichten 18 der zweiten Folie 2 (Verbundfolie 19) realisieren, etwa wie in Figur 8A bereits dargestellt. Insbesondere können auf der Unterseite 2b der Verbundfolie 19 angeordnete Ausnehmungen 17 einen Grundriss und/oder eine Flächenerstreckung wie in Figur 12 anhand der Emporwölbungen 16 erläutert aufweisen.

Die in Figur 13 gezeigten Überhänge 28 (sowie die entsprechenden Überhänge 28 in den nachfolgenden Figuren 15 und 17) der Membranfolie 3 - und optional auch der Materiallage 15 - über den inneren Enden 11 der Lüftungskanäle 7 decken diese inneren Enden zwar ab, d.h. verhindern deren Nutzung für den Lufttransport zum Druckausgleich. Der Vorteil dieser größer dimensionierten Membran, die als Überhänge 28 dienende Flächenbereiche aufweist, besteht aber darin, dass ein (toleranzbedingter, bei der Herstellung nicht vollständig vermeidbarer) seitlicher Versatz der Membranfolie nicht mehr dazu führen kann, dass irgendeiner der Lüftungskanäle 7 versehentlich durch die zweite Folie vollständig abgedeckt würde. Durch die Überhänge 28 wird somit verhindert, dass im Falle einer Fehlpositionierung der Membranfolie (gegenüber der ersten und/oder der zweiten Folie) der Innenrand 29 des Auflageflächenbereichs 9 bei irgendeinem der Lüftungskanäle 7 näher an der Flächenmitte des Etiketts zu liegen kommt als das innerste Ende 11 des betreffenden Lüftungskanals 7, wodurch dieser betreffende Lüftungskanal versperrt und wirkungslos würde.

Die Figuren 13 bis 17 zeigen somit weitere Ausführungsbeispiele zur verbesserten Positionierung des Verlaufs des Innenrandes 29 des Kontaktflächen- oder Auflageflächenbereichs 9 (zwischen der ersten Folie 1 und der zweiten Folie 2). Innerhalb des Innenrandes 29 des Auflageflächenbereichs 9 zwischen den Folien 1, 2 verläuft in deren Zwischenraum nämlich der weitere Lüftungsweg, durch den die Lüftungskanäle 7 bis zur Etikettenmitte (über der Membranfolie 3) verlängert werden. Selbstverständlich sind die Beispiele der Figuren 13 bis 17 wahlweise mit geschlossenen R1 bzw. R2 oder offenen Folienaußenrändern R1' oder R2' kombinierbar. Sie sind ebenso wahlweise mit oder ohne (optionalen) Abstandhalter 14 bzw. die dafür eingesetzte Materiallage 15 realisierbar. Ferner sind Grundriss, Größe und/oder Form aller Folien 1, 2, 3 sowie die Anzahl der Lüftungskanäle 7 variierbar. Entsprechende Abwandlungen sind ebenso auch für die Ausführungsbeispiele der Figuren 1A bis 12 denkbar.

Figur 13 zeigt konkret eine zu Figur 2C alternative Ausführungsform, wobei nun die Membranfolie 3 einen jeweiligen Überhang 28 über dem inneren Ende jedes Lüftungskanals 7 bildet. Die Membranfolie (schraffiert dargestellt) ist beispielsweise quadratisch bzw. rechteckig; jedenfalls bedeckt sie die inneren Enden 11 der Lüftungskanäle 7. Weiterhin ist der Auflageflächenbereich 9 zwischen der ersten Folie 1 und der zweiten Folie 2 erkennbar und auch dessen Innenrand 29 (gestrichelt dargestellt), welcher das den weiteren Lüftungsweg bildende Luftvolumen zwischen den Folien 1 und 2 (bzw. 3 und 2 über der Membran) umschließt. Wie in Figur 13 erkennbar ist, reicht dieser Innenrand 29 zwar relativ nah an den Außenrand der Membranfolie 3 heran, ist aber von diesem noch ausreichend beabstandet, sodass Luft zwischen dem äußeren Membranrand und dem Innenrand 29 des Auflageflächenbereichs 9 hinab in die Lüftungskanäle 7 der ersten Folie 1 strömen kann (oder - in umgekehrter Richtung - von dort hinauf über den Rand der Membranfolie hinweg bis zur Membranoberseite 3a strömen kann). Dieser seitliche Abstand (rundherum um die Membranfolie) zwischen dem äußeren Membranrand und dem Innenrand 29 des Auflageflächenbereichs 9 fällt zwar in Figur 13 (z.B. infolge einer geringen Membranstärke bzw. Schichtdicke) relativ gering aus, ist aber ausreichend groß, um den Lüftungsweg zwischen den Lüftungskanälen 7 nicht zu unterbrechen. Ein solcher Abstand zwischen dem äußeren Membranrand und dem Innenrand 29 des Auflageflächenbereichs 9 liegt auch in den übrigen Ausführungsbeispielen vor (insbesondere denjenigen der Figuren 2A bis 7 und 11), auch wenn dieser Abstand lediglich in Figur 6B zeichnerisch dargestellt (und wegen der dort um den Abstandhalter 14 vergrößerten Schichtdicke gegenüber der Membran alleine wesentlich größer dargestellt wurde (vgl. die Position des Bezugszeichens 29 in Figur 6B).

Figur 14 zeigt eine die Figur 2A ergänzende schematische Ansicht, in der der Auflageflächenbereich 9 und sein Innenrand 29 (gestrichelt dargestellt) zusätzlich erkennbar sind. Die Membranfolie 3 reicht wiederum - eigentlich - soweit an das innere Ende 11 jedes Lüftungskanals 7 heran, dass der Innenrand 29 des Kontaktflächenbereichs 9 der beiden Folien 1, 2 (bei dem angewandten Herstellungsschritt des Zukaschierens bzw. Aufeinanderpressens beider Folien 1, 2) weiter außen liegt als das innere Ende 11 des betreffenden Lüftungskanals 7. Im Falle einer toleranzbedingten Fehlpositionierung der Membranfolie jedoch könnten ein oder mehrere Lüftungskanäle 7 versehentlich an ihrem inneren Ende 11 verschlossen werden.

Figur 15 zeigt eine zu den Figuren 2A und 14 alternative Ausführungsform, bei der das Risiko eines derartigen Kanalverschlusses dadurch verringert ist, dass die Membranfolie Überhänge 28 über dem inneren Ende 11 jedes der Lüftungskanäle 7 aufweist. Der Innenrand 29 des Kontaktflächenbereichs 9 liegt im Vergleich zu Figur 14 weiter außen.

Figur 16 zeigt eine ergänzende schematische Ansicht zu Figur 2B - wiederum mit zusätzlicher Darstellung des Auflageflächenbereichs 9 und seines Innenrandes 29. Im Gegensatz zu Figur 6B liegt dieser wesentlich näher an dem Außenrand der Membran - sei es, weil hier der Abstandhalter 14 fehlt, oder sei es, weil die Membran 3 und der Abstandhalter 14 (gleicher oder abweichender Kontur im Vergleich zur Membran) geringere Schichtdicken besitzen als in Figur 6B. Obwohl die Membran 3 und/oder der Abstandhalter 14 mit seitlichen Ausbuchtungen 21 versehen sind und die inneren Enden 11 der Lüftungskanäle 7 U-förmig umschließen (wie schon in Figur 2B, 2C oder 6B), könnte im Falle eines Versatzes der Membran und/oder des Abstandhalters 14 noch ein gewisses Risiko einzelner Kanalverschlüsse bestehen.

Figur 17 zeigt daher eine gegenüber den Figuren 2B und 16 abgewandelte Ausführungsform, bei welcher - zusätzlich zu den seitlichen Ausbuchtungen 21 der Membran 3 und/oder des Abstandhalters 14 - die Membran 3 und/oder der Abstandhalter 14 außerdem noch als Überhang 28 dienende Flächenbereiche über dem inneren Ende 11 jedes der Lüftungskanäle 7 aufweisen. Die Überhänge 28 sind hier als gerade Randbereiche dargestellt; sie stellen gegenüber Figur 16 eine Verkürzung der Einschnürungen 22 zwischen den benachbarten Ausbuchtungen 21 dar.

Gemäß den Figuren 16 und 17 ist bei lagerichtiger Position der Membranfolie 3 und/oder des Abstandhalters 14 der gestrichelt dargestellte Innenrand 29 des Auflageflächenbereichs 9 allseitig genügend weit von den inneren Enden 11 der Lüftungskanäle 7 entfernt; gerade wegen der Ausbuchtungen 21. Lediglich bei besonders geringer Schichtdicke der Membran und/oder des Abstandhalters 14 könnte zwischen benachbarten Ausbuchtungen 21 der Innenrand 29 des Auflageflächenbereichs 9 gefährlich nah an das innere Kanalende 11 zu liegen kommen - wie in Figur 17 exemplarisch durch den gepunkteten (statt gestrichelten) Innenrand 29' am linken und unteren Lüftungskanal 7 dargestellt - und dann diesen Kanal verschließen, sobald die Fehlpositionierung der Membranfolie einen gewissen Toleranzwert überschreitet. Aber selbst dann ist dank der Überhänge 28 der Membran (und alternativ oder zusätzlich infolge der Überhänge des Abstandhalters 14) gewährleistet, dass keiner der inneren Kanalenden 11 verschlossen wird.

Figur 18 zeigt schematisch eine exemplarische Ausführungsart hinsichtlich eines Verfahrens zum Herstellen einer Vielzahl von Druckausgleichsetiketten 10. Bei diesem Verfahren wird zunächst eine Materialbahn I bearbeitet, deren Aufbau in Figur 18 links oben vergrößert dargestellt ist. Die Materialbahn I umfasst eine erste Folienbahn 101, eine erste Klebeschutzfolie 31 und eine zweite Klebeschutzfolie 32. Die erste Folienbahn 101 weist oberseitig und unterseitig jeweils eine Klebstoffschicht auf, d.h. sie ist beidseitig klebend. Gemäß Figur 18 ist beispielsweise die erste Klebeschutzfolie 31 auf der oberseitigen Klebstoffschicht angeordnet und die zweite Klebeschutzfolie 32 auf der unterseitigen Klebstoffschicht angeordnet. Als Klebeschutzfolien 31, 32 dienen beispielsweise silikonisierte Polymerfolien oder silikonisiertes Papier (vgl. auch die Ausführungen zu den Figuren 1A bis 1C). Die zwischen der ersten Klebeschutzfolie 31 und der zweite Klebeschutzfolie 32 angeordnete, beidseitig klebende erste Folienbahn 101 dient als Ausgangsmaterial zur Herstellung der ersten Folie 1 für eine Vielzahl herzustellender Druckausgleichsetiketten 10. In Figur 18 sind die oberseitige und die unterseitige Klebstoffschicht der ersten Folienbahn 101 als schraffierte Bereiche nahe der beiden Klebeschutzfolien 31, 32 dargestellt.

Die Materialbahn I kann beispielsweise in Form vieler Bögen oder, wie in Figur 18 dargestellt, als Rollenware vorliegen. So wird beispielsweise zur Durchführung des nachfolgend beschriebenen Verfahrens eine Spule S1 dieser Materialbahn I abgewickelt, d.h. diese Materialbahn von der Spule S1 abgerollt (Bezugszeichen A).

Zunächst werden in Schritt a) des Verfahrens durch eine geeignete Stanze die Aussparungen 6 und Lüftungskanäle 7 für die Etiketten in die Materialbahn I gestanzt. Der Stanzvorgang wird so ausgeführt, dass die zweite Klebeschutzfolie 32 (in Figur 18 beispielsweise die unterseitige Klebeschutzfolie) unversehrt bleibt und die Umrisse der Aussparungen 6 und Lüftungskanäle 7 nur durch die Schichten der ersten Klebeschutzfolie 31 und der ersten Folienbahn 101 hindurch gestanzt werden (Bezugszeichen B). Anschließend wird in Schritt b) (Bezugszeichen C) die zweite Klebeschutzfolie 32 abgezogen bzw. abgerollt. Dabei bleiben die zunächst innerhalb der Stanzumrisse befindlichen Stücke der ersten Folienbahn 101 und der ersten Klebeschutzfolie 31 an der zweiten Klebeschutzfolie 32 haften, d.h. werden gemeinsam mit dieser abgezogen bzw. abgehoben. In Schritt c) wird dann eine andere, dritte Klebeschutzfolie 33 an die so freigelegte Seite der ersten Folienbahn 101 angepresst bzw. aufgeklebt (Bezugszeichen D). Schließlich wird in Schritt d) die entgegengesetzte, erste Klebeschutzfolie 31 abgehoben bzw. abgezogen (Bezugszeichen E). Die Schritte c) und d) können auch gleichzeitig (in Figur 18 dann direkt übereinander an jeweils demselben Stück der Folienbahn 101) durchgeführt werden.

An dieser Stelle sei darauf hingewiesen, dass die Verfahrensschritte hier in derjenigen Reihenfolge beschrieben werden, wie sie nacheinander an einem jeweils konkreten, kleinen Stück der ersten Folienbahn 101 ausgeführt werden. Das gesamte Verfahren jedoch ist als Endlosprozess durchführbar, wobei kontinuierlich neues Material der Folienbahn 101 nachgeführt und bearbeitet wird, und zwar von allen Verfahrensschritten gleichzeitig. Insofern ist die Aufzählung der Verfahrensschritte zumindest in Bezug auf die Materiallage I bzw. in Bezug auf die Folienbahn 101 nicht im Sinne einer strengen Reihenfolge zu verstehen.

Die eine Seite (in Figur 18 die Unterseite) der Materialbahn ist nun wieder mit einer vollflächigen Klebeschutzfolie 33 bedeckt, wohingegen die andere Seite (in Figur 18 die Oberseite) der ersten Folienbahn 101 nun freiliegt und nicht nur Stanzkonturen, sondern echte Aussparungen 6 und Lüftungskanäle 7 aufweist, die an der klebenden Seite freiliegen. Nun wird in Schritt e) eine Vielzahl einzelner Membranfolien 3 über die Aussparungen 6 geklebt. Dabei werden auch die Folienbereiche 8 überklebt, die die Lüftungskanäle 7 von den Aussparungen 6 trennen. Die Zuführung und Aufbringung der Membranfolien 3 (Bezugszeichen F) erfolgt durch eine geeignet automatisierte Einheit oder Maschine, die beispielsweise eine kontinuierliche Membranfolienbahn (nicht dargestellt) in gleich große Folienstücke von Membranfolien 3 zerteilt, diese in vordefinierten identischen Abständen auf eine Rolle und/oder auf ein Förderband überträgt und von dort aus dann positionsgenau über die Aussparungen 6 der oberseitig klebenden ersten Folienbahn 101 positioniert und aufdrückt. Auf ähnliche Weise kann - optional - in einem nachfolgenden Verfahrensschritt (Bezugszeichen G) eine Vielzahl einzelner Abstandhalter 14 , die als zusätzliche Materiallage 15 zwischen den Membranfolien 3 und der noch aufzubringenden zweiten Folienbahn 102 dienen, zugeführt und aufgebracht werden.

Schließlich wird in Schritt f) auf die so präparierte Materialbahn (von der Seite der Membranfolie 3 bzw. der freiliegenden, klebenden Seite der ersten Folienbahn 1 her) die zweite Folienbahn 102 aufgebracht (Bezugszeichen H). So entsteht eine bearbeitete Materialbahn II als Endlosbahn. Diese kann zur späteren Verwendung auf eine weitere Spule S2 aufgewickelt oder auch sofort zu Druckausgleichsetiketten 10 weiterverarbeitet werden. Für Letzteres ist nur noch erforderlich, aus der Materialbahn II die letztendlichen Druckausgleichsetiketten 10 auszustanzen. Dies kann durch einen Stanzvorgang geschehen (nicht dargestellt, aber in Figur 18 zwischen H und S2 durchführbar), bei dem die erste und die zweite Folienbahn 101, 102 durchtrennt werden und so eine Vielzahl von Druckausgleichsetiketten 10, wie sie in dieser Anmeldung beschrieben sind, gebildet werden. Jede dieser Etiketten 10 weist genau eine Aussparung zum Überkleben einer Druckausgleichsöffnung 40 sowie einen oder mehrere Lüftungskanäle 7 auf. Bei diesem Stanzvorgang wird der Außenrand der Druckausgleichsetiketten 10 gestanzt, d.h. (je nach Ausführungsform der vorangehenden Figuren) die Ränder R1 und R2 bzw. alternativ die Ränder R1' und R2'. Hierbei werden in jedem Fall beide Folienbahnen 101, 102 gleichzeitig bzw. durch denselben Verfahrensschritt durchstanzt, sodass vollständige, fertige Etiketten hergestellt werden.

Bei diesem Vorgang kann zugleich auch die dritte Klebeschutzfolie 33 mitgestanzt werden oder alternativ dazu auch unversehrt gelassen werden, sodass die Druckausgleichsetiketten 10 weiterhin auf der dritten Klebeschutzfolie 33 als letztendlicher Trägerfolie haften bleiben. Um die einzelnen Etiketten herum kann das Gitter noch abgezogen werden; es entsteht versandfertige Rollenware mit Druckausgleichsetiketten 10, die sehr einfach aufgebaut und sehr kostengünstig hergestellt sind und insbesondere mit weniger Folienschichten als herkömmliche Etiketten auskommen.

Wie anhand Figur 18 erkennbar ist, lässt sich das gesamte Verfahren, obwohl es eine Mehrzahl von Verfahrensschritten umfasst, in einem einzigen Arbeitsgang durchführen, der sogar kontinuierlich, d.h. zur Verwendung einer einzigen kontinuierlich zugeführten und weiterbearbeiteten Materialbahn durchführbar ist. Dies ist von herkömmlichen Druckausgleichs-etiketten bzw. deren Herstellungsverfahren nicht bekannt; üblicherweise müssen zunächst unabhängig voneinander ein Membranetikett, also das eigentliche, klebende Belüftungselement, und separat davon das obere Schutzetikett gefertigt und diese beiden Teiletiketten dann passgenau aufeinandergepresst werden. Hierzu sind herkömmlich regelmäßig zunächst zwei getrennte Materialbahnen vorzubearbeiten, bevor diese (ggf. nach entsprechender Ummontierung oder Zwischenlagerung) in einem späteren Verfahrensschritt zu einer einheitlichen Materialbahn zusammengefügt werden können. Dementsprechend sind herkömmlich eigentlich sogar drei Durchläufe von Materialbahnen durch jeweilige Bearbeitungsstraßen erforderlich, um fertige Druckausgleichsetiketten 10 zu erhalten. Bei dem Verfahren gemäß der vorliegenden Anmeldung hingegen genügt ein einziger Durchlauf einer Materialbahn I, um eine Vielzahl fertiger Druckausgleichsetiketten 10 herzustellen - sogar schon vorkonfektioniert als vertriebsfertige Rollenware.

### Bezugszeichenliste

- 1: erste Folie
- 1a: Oberseite
- 1b: Unterseite
- 2: zweite Folie
- 2a: Oberseite
- 2b: Unterseite
- 3: Membranfolie
- 3a: Oberseite
- 3b: Unterseite
- 4, 5: Klebeschicht
- 6: Aussparung
- 7: Lüftungskanal
- 8: Folienbereich
- 9: Auflageflächenbereich
- 10: Druckausgleichsetikett
- 11: inneres Ende
- 12: äußeres Ende
- 13: Kanalaustrittsöffnung
- 14: Abstandhalter
- 15: Materiallage
- 16; 16': Emporwölbung
- 17: Ausnehmung
- 18: Teilschicht
- 19: Verbundfolie
- 20: Gegenstand
- 21: Ausbuchtung
- 22: Einschnürung
- 23: Beschriftung
- 24: Komponente
- 25: Gehäuse
- 26: Gehäusewand
- 27: Innenraum
- 28: Überhang
- 29; 29': Innenrand
- 30: Oberfläche
- 31: erste Klebschutzfolie
- 32: zweite Klebschutzfolie
- 33: dritte Klebschutzfolie
- 40: Druckausgleichsöffnung
- 101: erste Folienbahn
- 102: zweite Folienbahn
- A, B, ..., H: Bearbeitungsschritt
- d1: Schichtdicke
- I, II: Materialbahn
- L: Lüftungsweg
- R1,R1',R2,R2': Außenrand
- S1, S2: Spule

## Patentansprüche

1. Druckausgleichsetikett (10) zum Aufkleben auf eine mit einer Druckausgleichsöffnung versehene Oberfläche eines Gehäuses oder eines sonstigen Gegenstandes, wobei das Druckausgleichsetikett (10) Folgendes aufweist:
- eine erste Folie (1) zum Aufkleben auf eine mit einer Druckausgleichsöffnung versehene Oberfläche,
- eine äußere, zweite Folie (2) und
- eine luftdurchlässige Membranfolie (3), die zwischen der ersten Folie (1) und der zweiten Folie (2) angeordnet ist,
- **gekennzeichnet dadurch, dass** die erste Folie (1) eine zum Positionieren über einer Druckausgleichsöffnung bestimmte Aussparung (6) sowie eine Anzahl von Lüftungskanälen (7) aufweist und wobei jeder der Lüftungskanäle (7) durch einen Folienbereich (8) der ersten Folie (1) von der Aussparung (6) getrennt ist,
- wobei die Membranfolie (3) die Aussparung (6) und jeden der Folienbereiche (8) zwischen der Aussparung (6) und der Anzahl von Lüftungskanälen (7) bedeckt und
- wobei die äußere, zweite Folie (2) sich seitlich über die Membranfolie (3) hinaus erstreckt, seitlich außerhalb der Membranfolie (3) zumindest bereichsweise die Anzahl von Lüftungskanälen (7) der ersten Folie (1) abdeckt und einen Lüftungsweg (L) überspannt, der von derjenigen Oberfläche der Membranfolie (3), die der zweiten Folie (2) zugewandt ist, bis zu der Anzahl von Lüftungskanälen (7) der ersten Folie (1) führt.

2. Druckausgleichsetikett nach Anspruch 1,
**dadurch gekennzeichnet, dass**
der oder die Lüftungskanäle (7) von der Aussparung (6) beabstandete weitere Aussparungen der ersten Folie (1) sind.

3. Druckausgleichsetikett nach Anspruch 1 oder 2,
**dadurch gekennzeichnet, dass**
jeder der Lüftungskanäle (7) an einem Außenrand (R1') der ersten Folie (1) aus dem Druckausgleichsetikett (10) herausführt.

4. Druckausgleichsetikett nach Anspruch 1 oder 2,
**dadurch gekennzeichnet, dass**
die zweite Folie (2) über einem äußeren Ende (12) jedes der Lüftungskanäle (7) der ersten Folie (1) eine Kanalaustrittsöffnung (13) aufweist, durch die der Lüftungskanal (7) zugänglich ist, wobei die jeweilige Kanalaustrittsöffnung (13) in Form einer Aussparung, Durchstanzung, Anstanzung, aufgebogenen Folienfläche, Schnittlinie oder sonstigen Öffnung ausgebildet ist.

5. Druckausgleichsetikett nach einem der Ansprüche 1 bis 4,
**dadurch gekennzeichnet, dass**
die zweite Folie (2) in einem seitlich außerhalb der Membranfolie (3) befindlichen Auflageflächenbereich (9) mit der ersten Folie (1) und/oder einer darüber angeordneten Klebeschicht (4) verbunden ist und dass jeder der Lüftungskanäle (7) näher an die Membranfolie (3) heranführt als der Auflageflächenbereich (9).

6. Druckausgleichsetikett nach einem der Ansprüche 1 bis 5,
**dadurch gekennzeichnet, dass**
das Druckausgleichsetikett (10) einen luftdurchlässigen Abstandhalter (14) zwischen der Membranfolie (3) und der zweiten Folie (2) aufweist.

7. Druckausgleichsetikett nach Anspruch 6,
**dadurch gekennzeichnet, dass**
der Abstandhalter (14) eine luftdurchlässige Materiallage (15) aus einem Vlies, Filz, Stoff, Gewebe oder sonstigen luftdurchlässigen Material ist.

8. Druckausgleichsetikett nach einem der Ansprüche 1 bis 7,
**dadurch gekennzeichnet, dass**
das Druckausgleichsetikett (10) mindestens drei Lüftungskanäle (7) in der ersten Folie (1) aufweist und dass die Membranfolie (3) und/oder der Abstandhalter (14) in Richtung der Lüftungskanäle (7) Aussparungen, Einschnürungen (22) oder zumindest eine kleinere seitliche Ausdehnung besitzt als in Richtungen zwischen benachbarten Lüftungskanälen (7).

9. Druckausgleichsetikett nach einem der Ansprüche 1 bis 8,
**dadurch gekennzeichnet, dass**
die erste Folie (1) zwei, drei, vier, sechs oder eine sonstige Mehrzahl von Lüftungskanälen (7) aufweist, die symmetrisch um die für die Druckausgleichsöffnung bestimmte Aussparung (6) herum angeordnet sind.

10. Druckausgleichsetikett nach einem der Ansprüche 1 bis 9,
**dadurch gekennzeichnet, dass**
die erste Folie (1) eine beidseitig klebende Folie ist und dass die zweite Folie (2) in einem seitlich außerhalb der Membranfolie (3) befindlichen Auflageflächenbereich (9) mit der ersten Folie (1) verklebt ist.

11. Druckausgleichsetikett nach einem der Ansprüche 1 bis 10,
**dadurch gekennzeichnet, dass**
die zweite Folie (2) in Flächenbereichen über und/oder nahe den Lüftungskanälen (7) der ersten Folie (1) Emporwölbungen (16), beispielsweise in Form von Prägungen, Riffelungen oder Knickungen, oder unterseitige Ausnehmungen (17) aufweist.

12. Gegenstand (20) mit einer Oberfläche (30), die mindestens eine Druckausgleichsöffnung (40) aufweist,
wobei die mindestens eine Druckausgleichsöffnung (40) mit einem Druckausgleichsetikett (10) nach einem der Ansprüche 1 bis 11 bedeckt ist.

13. Verfahren zum Herstellen von Druckausgleichsetiketten (10) gemäß Anspruch 1, wobei das Verfahren umfasst:
a) Stanzen (B) der Aussparungen (6) und der Lüftungskanäle (7) in eine beidseitig klebende, durchgehende erste Folienbahn (101), deren zwei Seiten mit einer ersten (31) und einer zweiten Klebeschutzfolie (32) bedeckt sind, wobei die erste Klebeschutzfolie (31) und die erste Folienbahn (1) durchstanzt werden, wohingegen die zweite Klebeschutzfolie (32) ungestanzt bleibt,
b) Entfernen (C) der ungestanzten zweiten Klebeschutzfolie (32) von der ersten Folienbahn (101) und dabei Entfernen (C) von Folienstücken der ersten Folienbahn (101) sowie von Folienstücken der ersten Klebeschutzfolie (31) jeweils aus den gestanzten Aussparungen (6) und Lüftungskanälen (7),
c) Aufkleben (D) einer dritten Klebeschutzfolie (33) auf die von der ersten Klebeschutzfolie (31) abgewandte Seite der ersten Folienbahn (101),
d) Freilegen der anderen Seite der gestanzten ersten Folienbahn (101) durch Entfernen (E) der ersten Klebeschutzfolie (31) von der ersten Folienbahn (101),
e) Aufkleben (F) von Einzelstücken von Membranfolien (3) auf die freigelegte Seite der ersten Folienbahn (101),
f) Aufkleben (H) einer zweiten Folienbahn (102) auf die mit den Membranfolien (3) bedeckte Seite der erste Folienbahn (101) und
g) Ausstanzen einer Vielzahl von Druckausgleichsetiketten (10) aus der so gebildeten, die erste Folienbahn (101) und die zweite Folienbahn (102) umfassenden Materialbahn.

14. Verfahren nach Anspruch 13,
**dadurch gekennzeichnet, dass**
in Schritt g) aus der ersten Folienbahn (101) eine Vielzahl erster Folien (1) und aus der zweiten Folienbahn (102) eine Vielzahl mit den ersten Folien (1) verbundener zweiter Folien (2) gestanzt wird.

15. Verfahren nach Anspruch 13 oder 14,
**dadurch gekennzeichnet, dass**
zwischen den Schritten e) und f) eine Vielzahl von Einzelstücken einer luftdurchlässigen Materiallage (15) auf die Membranfolien (3) und/oder auf die erste Folienbahn (101) aufbracht wird.

## Claims

1. A pressure equalization label (10) for sticking to a surface of a housing or any other object provided with a pressure equalization opening, the pressure equalization label (10) comprising:
- a first film (1) for sticking to a surface provided with a pressure equalization opening,
- an outer, second film (2) and
- an air-permeable membrane film (3) disposed between the first film (1) and the second film (2),
**characterized in that**
the first film (1) has a recess (6) intended to be positioned above a pressure equalization opening and a number of ventilation channels (7), and wherein each of the ventilation channels (7) is separated from the recess (6) by a film region (8) of the first film (1),
- the membrane film (3) covering the recess (6) and each of the film regions (8) between the recess (6) and the number of ventilation channels (7), and
- wherein the outer, second film (2) extends laterally beyond the membrane film (3), covers the number of ventilation channels (7) of the first film (1) laterally outside the membrane film (3) at least in regions and spans a ventilation path (L) which extends from that surface of the membrane film (3) which faces the second film (2) up to the number of ventilation channels (7) of the first film (1).

2. The pressure equalization label according to claim 1,
**characterized in that**
the ventilation channel(s) (7) is/are implemented by further recesses of the first film (1) which are spaced from the recess (6).

3. The pressure equalization label according to claim 1 or 2,
**characterized in that**
each of the ventilation channels (7) extends to the outside of the pressure equalization label (10) at an outer edge (R1') of the first film (1).

4. The pressure equalization label according to claim 1 or 2,
**characterized in that**
the second film (2) has, above an outer end (12) of each of the ventilation channels (7) of the first film (1), a channel outlet opening (13) through which the ventilation channel (7) is accessible, the respective channel outlet opening (13) being realized in the form of a recess, full punching, partial punching, bent-up film surface, cutting line or any other opening.

5. The pressure equalization label according to any of claims 1 to 4,
**characterized in that**
the second film (2) is connected to the first film (1) and/or an adhesive layer (4) arranged above it in a contact surface region (9) located laterally outside the membrane film (3) and **in that** each of the ventilation channels (7) comes closer to the membrane film (3) than the contact surface region (9).

6. The pressure equalization label according to any of claims 1 to 5,
**characterized in that**
the pressure equalization label (10) has an air-permeable spacer (14) between the membrane film (3) and the second film (2) .

7. The pressure equalization label according to claim 6,
**characterized in that**
the spacer (14) is an air-permeable material layer (15) made of a non-woven material, felt, cloth, fabric or any other air-permeable material.

8. The pressure equalization label according to any of claims 1 to 7,
**characterized in that**
the pressure equalization label (10) has at least three ventilation channels (7) in the first film (1) and that the membrane film (3) and/or the spacer (14) have recesses, constrictions (22) or at least a smaller lateral expansion in the direction of the ventilation channels (7) than in the directions between adjacent ventilation channels (7).

9. The pressure equalization label according to any of claims 1 to 8,
**characterized in that**
the first film (1) has two, three, four, six or any other plurality of ventilation channels (7) which are symmetrically arranged around the recess (6) intended for the pressure equalization opening.

10. The pressure equalization label according to any of claims 1 to 9,
**characterized in that**
the first film (1) is a double-sided adhesive film and the second film (2) is bonded to the first film (1) in a contact surface region (9) located laterally outside the membrane film (3).

11. The pressure equalization label according to any of claims 1 to 10,
**characterized in that**
the second film (2) has projections (16) in surface regions above and/or near the ventilation channels (7) of the first film (1), for example in the form of embossings, corrugations or bends, or has recesses (17) on the underside.

12. An object (20) with a surface (30) having at least one pressure equalization opening (40),
wherein the at least one pressure equalization opening (40) is covered with a pressure equalization label (10) according to any of claims 1 to 11.

13. A method of manufacturing pressure equalization labels (10) according to claim 1,
the method comprising:
a) punching (B) the recesses (6) and the ventilation channels (7) into a continuous, double-sided adhesive first film web (101), the two sides of which are covered with a first (31) and a second anti-stick film (32), wherein the first anti-stick film (31) and the first film web (1) are fully punched through, whereas the second anti-stick film (32) remains non-punched,
b) removing (C) the non-punched second anti-stick film (32) from the first film web (101) and thereby removing (C) pieces of film of the first film web (101) and pieces of film of the first anti-stick film (31) from the punched recesses (6) and ventilation channels (7), respectively,
c) gluing (D) a third anti-stick film (33) onto the side of the first film web (101) facing away from the first anti-stick film (31),
d) exposing the other side of the punched first film web (101) by removing (E) the first anti-stick film (31) from the first film web (101),
e) gluing (F) individual pieces of membrane foils (3) onto the exposed side of the first foil web (101),
f) gluing (H) a second film web (102) onto the side of the first film web (101) covered with the membrane films (3) and
g) punching a plurality of pressure equalization labels (10) out of the resulting material web comprising the first film web (101) and the second film web (102).

14. The method according to claim 13,
**characterized in that**
in step g) a plurality of first films (1) is punched out of the first film web (101) and a plurality of second films (2) connected to the first films (1) is punched out of the second film web (102).

15. The method according to claim 13 or 14,
**characterized in that**
between steps e) and f) a plurality of individual pieces of an air-permeable material layer (15) is applied onto the membrane films (3) and/or the first film web (101).

## Revendications

1. Étiquette de compensation de pression (10) destinée à être collée sur une surface pourvue d'une ouverture de compensation de pression d'un boîtier ou de tout autre objet, sachant que l'étiquette de compensation de pression (10) présente ce qui suit :
- une première feuille (1) destinée à être collée sur une surface pourvue d'une ouverture de compensation de pression,
- une deuxième feuille (2) extérieure et
- une feuille membrane (3) perméable à l'air qui est disposée entre la première feuille (1) et la deuxième feuille (2),
- **caractérisée en ce que** la première feuille (1) présente un évidement (6) destiné à être positionné au-dessus d'une ouverture de compensation de pression ainsi qu'un nombre de canaux d'aération (7) et sachant que chacun des canaux d'aération (7) est séparé de l'évidement (6) par une zone de feuille (8) de la première feuille (1),
- sachant que la feuille membrane (3) couvre l'évidement (6) et chacune des zones de feuille (8) entre l'évidement (6) et le nombre de canaux d'aération (7) et
- sachant que la deuxième feuille (2) extérieure s'étend latéralement au-delà de la feuille membrane (3), couvre au moins en partie le nombre de canaux d'aération (7) de la première feuille (1) latéralement à l'extérieur de la feuille membrane (3) et enjambe une voie d'aération (L) qui mène depuis la surface de la feuille membrane (3) qui est tournée vers la deuxième feuille (2) jusqu'au nombre de canaux d'aération (7) de la première feuille (1) .

2. Étiquette de compensation de pression selon la revendication 1,
**caractérisée en ce que**
le ou les canaux d'aération (7) sont des évidements supplémentaires de la première feuille (1) espacés de l'évidement (6).

3. Étiquette de compensation de pression selon la revendication 1 ou 2,
**caractérisée en ce que**
chacun des canaux d'aération (7) mène hors de l'étiquette de compensation de pression (10) au niveau d'un bord extérieur (R1') de la première feuille (1).

4. Étiquette de compensation de pression selon la revendication 1 ou 2,
**caractérisée en ce que**
la deuxième feuille (2) présente, au-dessus d'une extrémité (12) extérieure de chacun des canaux d'aération (7) de la première feuille (1), une ouverture de sortie de canal (13) par laquelle le canal d'aération (7) est accessible, sachant que l'ouverture de sortie de canal (13) respective est constituée sous forme d'un évidement, d'une perforation, d'une découpe, d'une face de feuille recourbée, d'une ligne de coupe ou de toute autre ouverture.

5. Étiquette de compensation de pression selon l'une des revendications 1 à 4,
**caractérisée en ce que**
la deuxième feuille (2), dans une zone de face d'appui (9) située latéralement à l'extérieur de la feuille membrane (3), est reliée à la première feuille (1) et/ou à une couche adhésive (4) disposée au-dessus de celle-ci et **en ce que** chacun des canaux d'aération (7) s'approche davantage de la feuille membrane (3) que la zone de face d'appui (9).

6. Étiquette de compensation de pression selon l'une des revendications 1 à 5,
**caractérisée en ce que**
l'étiquette de compensation de pression (10) présente une entretoise (14) perméable à l'air entre la feuille membrane (3) et la deuxième feuille (2).

7. Étiquette de compensation de pression selon la revendication 6,
**caractérisée en ce que**
l'entretoise (14) est une couche de matière (15) perméable à l'air composée d'une toile, d'un feutre, d'une étoffe, d'un tissu ou de toute autre matière perméable à l'air.

8. Étiquette de compensation de pression selon l'une des revendications 1 à 7,
**caractérisée en ce que**
l'étiquette de compensation de pression (10) présente au moins trois canaux d'aération (7) dans la première feuille (1) et **en ce que** la feuille membrane (3) et/ou l'entretoise (14) possède, en direction des canaux d'aération (7), des évidements, des rétrécissements (22) ou du moins une dilatation latérale plus petite que dans des directions entre des canaux d'aération (7) adjacents.

9. Étiquette de compensation de pression selon l'une des revendications 1 à 8,
**caractérisée en ce que**
la première feuille (1) présente deux, trois, quatre, six ou toute autre pluralité de canaux d'aération (7) qui sont disposés symétriquement autour de l'évidement (6) destiné à l'ouverture de compensation de pression.

10. Étiquette de compensation de pression selon l'une des revendications 1 à 9,
**caractérisée en ce que**
la première feuille (1) est une feuille adhésive des deux côtés et **en ce que** la deuxième feuille (2) est collée à la première feuille (1) dans une zone de face d'appui (9) située latéralement à l'extérieur de la feuille membrane (3).

11. Étiquette de compensation de pression selon l'une des revendications 1 à 10,
**caractérisée en ce que**
la deuxième feuille (2) présente des voussures vers le haut (16), par exemple sous forme d'empreintes, de striations ou de plis, ou des cavités (17) de côté inférieur, dans des zones de surface au-dessus et/ou près des canaux d'aération (7) de la première feuille (1).

12. Objet (20) comportant une surface (40) qui présente au moins une ouverture de compensation de pression (40),
sachant que l'au moins une ouverture de compensation de pression (40) est couverte par une étiquette de compensation de pression (10) selon l'une des revendications 1 à 11.

13. Procédé de fabrication d'étiquettes de compensation de pression (10) selon la revendication 1, sachant que le procédé comprend :
a) le découpage (B) des évidements (6) et des canaux d'aération (7) dans une première bande de feuille (101) continue adhésive des deux côtés dont les deux côtés sont couverts par une première (31) et une deuxième feuille de protection adhésive (32), sachant que la première feuille de protection adhésive (31) et la première bande de feuille (1) sont perforées, la deuxième feuille de protection adhésive (32) restant en revanche non découpée,
b) le fait d'enlever (C) la deuxième feuille de protection adhésive (32) non découpée de la première bande de feuille (101) tout en enlevant (C) des morceaux de feuille de la première bande de feuille (101) ainsi que des morceaux de feuille de la première feuille de protection adhésive (31) respectivement hors des évidements (6) et canaux d'aération (7) découpés,
c) le collage (D) d'une troisième feuille de protection adhésive (33) sur le côté de la première bande de feuille (101) qui est opposé à la première feuille de protection adhésive (31),
d) le fait de dégager l'autre côté de la première bande de feuille (101) découpée en enlevant (E) la première feuille de protection adhésive (31) de la première bande de feuille (101),
e) le collage (F) de morceaux individuels de feuilles membranes (3) sur le côté dégagé de la première bande de feuille (101),
f) le collage (H) d'une deuxième bande de feuille (102) sur le côté de la première bande de feuille (101) qui est couvert par les feuilles membranes (3) et
g) le découpage d'une pluralité d'étiquettes de compensation de pression (10) à partir de la bande de matière ainsi formée comprenant la première bande de feuille (101) et la deuxième bande de feuille (102).

14. Procédé selon la revendication 13,
**caractérisé en ce que**
à l'étape g), une pluralité de premières feuilles (1) est découpée à partir de la première bande de feuille (101) et une pluralité de deuxièmes feuilles (2) liées aux premières feuilles (1) est découpée à partir de la deuxième bande de feuille (102).

15. Procédé selon la revendication 13 ou 14,
**caractérisé en ce que**
entre les étapes e) et f), une pluralité de morceaux individuels d'une couche de matière (15) perméable à l'air est appliquée sur les feuilles membranes (3) et/ou sur la première bande de feuille (101).
